(19) Europäisches Patentamt
European Patent Office
Office européen des brevets

(11) EP 4 094 304 B1

(12) # FASCICULE DE BREVET EUROPEEN

(45) Date de publication et mention de la délivrance du brevet:
**16.04.2025 Bulletin 2025/16**

(21) Numéro de dépôt: **20845596.4**

(22) Date de dépôt: **16.12.2020**

(51) Classification Internationale des Brevets (IPC):
***H10N 30/092** (2023.01)* ***H10N 30/85** (2023.01)*

(52) Classification Coopérative des Brevets (CPC):
**H10N 30/092; H10N 30/852**

(86) Numéro de dépôt international:
**PCT/FR2020/052470**

(87) Numéro de publication internationale:
**WO 2021/130434 (01.07.2021 Gazette 2021/26)**

(54) **MATERIAUX COMPOSITES PIEZOELECTRIQUES AYANT DES PROPRIETES PIEZOELECTRIQUES AMELIOREES**

PIEZOELEKTRISCHE VERBUNDMATERIALIEN MIT VERBESSERTEN PIEZOELEKTRISCHEN EIGENSCHAFTEN

PIEZOELECTRIC COMPOSITE MATERIALS WITH IMPROVED PIEZOELECTRIC PROPERTIES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.12.2019 FR 1915438**

(43) Date de publication de la demande:
**30.11.2022 Bulletin 2022/48**

(73) Titulaire: **COMPAGNIE GENERALE DES ETABLISSEMENTS MICHELIN**
**63000 Clermont-Ferrand (FR)**

(72) Inventeurs:
- **PIBRE, Guillaume**
**63040 Clermont-Ferrand Cedex 9 (FR)**
- **LAFORT, François**
**63040 Clermont-Ferrand Cedex 9 (FR)**

(74) Mandataire: **M.F.P. Michelin**
**DCJ/PI - F35 - Ladoux**
**23 place des Carmes-Déchaux**
**63040 Clermont-Ferrand Cedex 9 (FR)**

(56) Documents cités:
**EP-A1- 2 071 584** **JP-A- 2016 065 209**
**US-A1- 2019 058 108** **US-A1- 2019 284 423**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

La présente invention concerne un matériau composite piézoélectrique, son procédé d'obtention et l'utilisation d'un tel matériau dans des dispositifs tels que des actionneurs et/ou détecteurs piézoélectriques, des générateurs d'énergie.

De nombreux articles comprennent des matériaux composites piézoélectriques pour leur fonctionnement. On les trouve, en effet, dans les transducteurs acoustiques, dans des capteurs de pression et/ou d'accélération, des générateurs d'énergie, des matériaux d'isolants phoniques, dans des actionneurs et/ou détecteurs piézoélectriques utilisés par exemple dans la microscopie électronique à force atomique ou bien utilisés dans des pneumatiques pour suivre le comportement de ce dernier.

La piézoélectricité est un phénomène physique qui correspond à l'apparition d'une polarisation électrique induite par une déformation mécanique extérieure. Il s'agit d'un couplage électromécanique où la polarisation est proportionnelle à la contrainte mécanique appliquée jusqu'à un certain niveau. L'effet piézoélectrique est alors dit direct. Ce phénomène est réversible : lorsque le matériau est soumis à un champ électrique extérieur, il se déforme. Il s'agit de l'effet piézoélectrique inverse.

Une variation de la polarisation macroscopique lors de l'application d'une contrainte sur l'échantillon caractérise l'effet piézoélectrique. Dans un système d'axes orthogonaux, la polarisation et la contrainte sont liées en notation matricielle par un tenseur de rang 2 appelé tenseur piézoélectrique $d_{ij}$ avec i et j correspondant respectivement à l'axe de polarisation (1, 2, 3) et d'application de la contrainte (1, 2, 3, 4, 5, 6) comme indiqué sur la figure 1.

On classe les matériaux qui ont des propriétés piézoélectriques en trois grandes classes : les piézoélectriques inorganiques, les polymères piézoélectriques et les matériaux composites piézoélectriques.

Ces trois grandes classes de matériaux piézoélectriques n'ont notamment pas les mêmes propriétés de permittivité diélectriques, de polarisation rémanente, de champ coercitif, etc.

Les propriétés des piézoélectriques inorganiques, telles que par exemples, les titanozirconates de plomb (PTZ), sont très souvent liées à leur structure cristalline, tandis que celles des polymères piézoélectriques (matériaux organiques) proviennent de la présence de dipôles permanents intrinsèques des monomères constituants ces polymères. Le polymère piézoélectrique le plus connu est le PVDF.

Un matériau composite piézoactif ou piézoélectrique comprend au moins un matériau piézoélectrique, qui confère au matériau composite son activité piézoélectrique, et une ou plusieurs phases non piézoélectriques. Cette association conduit à un matériau composite dont les performances sont accrues par rapport à chaque phase seule. La phase non piézoélectrique est en général une matrice polymère organique, notamment une matrice polymère rigide thermoplastique ou thermodurcissable (US2015/134061 A1, WO2016/157092 A1) qui peut être de type polyamide (Capsal et al. Journal of non-crystalline solids 2010, 356, 629-634), polyépoxy (Furukawa et al. Jpn. J. Appl. Phys. 1976, 15, 2119), polystyrène, polyuréthane (Hanner et al. Ferroelectrics 1989, 100, 255-260), PVC (Liu et al. Materials Science and Engineering 2006, 127, 261-266) ou encore polyéthylène (Rujijanagul et al. Journal of Materials Science Letters 2001, 20, 1943-1945), une matrice polymérique comprenant de l'alcool polyvinylique cyanoéthylé (EP2654094 A1) ou une matrice polymérique comprenant un élastomère diénique (WO2019/243750 A1).

Le document US2019/0284423 A1 décrit un composite piézoélectrique comprenant un polymère piézoélectrique et des charges sous formes de particules dispersées dans le polymère, dans lequel la charge est sous forme de micro-nanoparticules.

Le document US2019/058108 A1 divulgue un dispositif comprenant un matériau piézoélectrique et deux couches formant chacune les électrodes. Le matériau piézoélectrique est une composition polymère diélectrique obtenue par polymérisation d'au moins un monomère vinylique en présence d'un liquide ionique et le document EP2071584 A1 divulgue un dispositif piézoélectrique comprenant un élément d'actionnement piézoélectrique entouré d'électrodes et un polymère électrolyte comprenant un liquide ionique et un bloc de copolymère spécifique.

Les propriétés piézoélectriques sont utilisées dans de nombreuses applications avec une miniaturisation croissante, ce qui nécessite de disposer de matériaux composites ayant des propriétés piézoélectriques de plus en plus élevées.

La présente invention a donc pour but de remédier à ce besoin et de proposer un nouveau matériau composite piézoélectrique présentant des propriétés piézoélectriques améliorées par rapport aux matériaux composites piézoélectriques de l'art antérieur.

Le déposant a trouvé que l'ajout d'un composé spécifique, un liquide ionique, à un matériau composite piézoélectrique permettait, de manière surprenante, d'en améliorer ses propriétés piézoélectriques.

Ainsi l'invention concerne un matériau composite piézoélectrique à base d'une matrice polymérique et de charges inorganiques piézoélectriques, caractérisé en ce que ledit matériau comprend en outre au moins un liquide ionique de formule générale $Q^+A^-$, dans laquelle $Q^+$ représente un cation choisi parmi les cations ammoniums quaternaires et les cations phosphoniums quaternaires et $A^-$ représente tout anion qui sont adaptés à former un sel liquide à une température inférieure à 100°C.

Plus particulier, le matériau composite piézoélectrique selon l'invention peut présenter avantageusement au moins l'une des caractéristiques préférées suivantes prises seules ou en combinaisons.

Préférentiellement, le cation Q+ est un cation ammonium quartenaire choisi dans le groupe constitué par les cations imidazolium, les cations pyrazolium, les cations pyridinium, les cations pyrimidinium, les cations tétra-alkyl(C1-C6)ammonium, les cations guanidium et les cations pyrrolidium.

Préférentiellement, le cation Q+ est un cation imidazolium répondant à la formule (I)

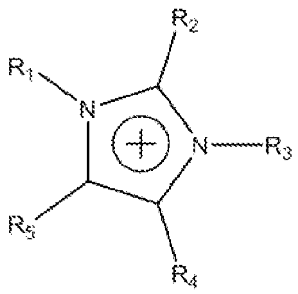

(I)

dans laquelle R1 représente un groupe alkyle comportant de 1 à 15 atomes de carbone, de préférence de 1 à 10 atomes de carbone, éventuellement substitué par un ou plusieurs groupements aryles en C6-C30, thiols, hydroxy ou interrompu par un ou plusieurs atomes d'oxygène ou de soufre ou par un ou plusieurs groupements NR', R2, R3, R4, R5 et R', identiques ou différents, représentent chacun un atome d'hydrogène ou un groupe alkyle comportant de 1 à 6 atomes, de carbone de préférence de 1 à 4 atomes de carbone, ou un groupe aryle en C6-C30, éventuellement substitué par un ou plusieurs groupes alkyles en C1-C4.

Préférentiellement, le cation Q+ est choisi dans le groupe constitué par le 1-éthyle-3-méthylimidazolium, le 1-butyl-3-méthylimidazolium, le 1-héxyl-m-méthylimidazolium, le 1-octyl-3-méthylimidazolium, le 1-décyl-3-méthylimidazolium, le 1,3-dibutylimidazolium et le 1-butyl-2,3-diméthylimidazolium.

Préférentiellement, l'anion $A^-$ est choisi dans le groupe constitué par l'acétate, le trifluoroacétate, le propionate, le chlorure, l'hydroxyle, le sulfate, le trifluorométhanesulfonate, le pentafluorométhanesulfonate et les phosphates ; de préférence $A^-$ est l'acétate ou le propionate.

Préférentiellement, le taux de liquide ionique est supérieur ou égal à 0,1 parties en poids pour cent partie en poids de polymère, de préférence est compris dans un domaine allant de 0,1 à 15 parties en poids pour cent partie en poids de polymère, plus préférentiellement de 0,5 à 12 parties en poids pour cent partie en poids de polymère, plus préférentiellement encore de 1 à 10 parties en poids pour cent partie en poids de polymère.

Préférentiellement, la charge inorganique piézoélectrique est choisie parmi les céramiques piézoélectriques, avantageusement choisie parmi les oxydes ferroélectriques, avantageusement ayant une structure pérovskite.

Préférentiellement, la charge inorganique piézoélectrique est choisie parmi le titanate de baryum, le titanate de plomb, le titano-zirconate de plomb, le niobate de plomb, le niobate de lithium, le niobate de potassium et leurs mélanges, plus préférentiellement la charge inorganique piézoélectrique est choisie parmi le titanate de baryum, le titano-zirconate de plomb, le niobate de potassium et leurs mélanges.

Préférentiellement, la charge inorganique piézoélectrique est choisie dans le groupe constitué par le titanate de baryum, le niobate de potassium et leurs mélanges.

Préférentiellement, la taille des particules la charge inorganique piézoélectrique est comprise dans un domaine allant entre 50 nm à 800 $\mu$m.

Préférentiellement, le taux de charges inorganiques piézoélectriques est compris dans un domaine allant de 5 % à 80 % en volume par rapport au volume total dudit matériau, plus préférentiellement de 6 % à 60 %, plus préférentiellement encore de 7 % à 50 %.

Préférentiellement, la matrice polymérique comprend au moins un polymère choisi dans le groupe constitué par les polymères thermoplastiques, les élastomères thermoplastiques, les polymères thermodurcissables, les élastomères diéniques et les mélanges de ces polymères.

Préférentiellement, la matrice polymérique comprend au moins un élastomère thermoplastique et/ou un élastomère diénique.

Préférentiellement, la matrice polymère comprend majoritairement un élastomère diénique.

Préférentiellement, la matrice polymère comprend de 75 pce à 100 pce, plus préférentiellement de 90 pce à 100 pce, plus préférentiellement encore de 95 à 100 pce d'élastomère diénique.

Préférentiellement, la matrice polymérique comprend au moins un élastomère diénique choisi dans le groupe constitué par le caoutchouc naturel, les copolymères d'éthylène-propylène-monomère diénique, les polyisoprènes de

synthèse, les polybutadiènes, les copolymères de butadiène, les copolymères d'isoprène et les mélanges de ces élastomères diéniques.

Préférentiellement, l'élastomère diénique de la matrice polymérique est choisi dans le groupe constitué par les polybutadiènes, les copolymères de butadiène-styrène, les copolymères de butadiène-isoprène, les copolymères de butadiène-styrène-isoprène et les mélanges de ces élastomères diéniques, plus préférentiellement, l'élastomère diénique est le copolymère styrène-butadiène.

Préférentiellement, le matériau composite piézoélectrique comprend en outre au moins un système de réticulation, de préférence ce système de réticulation comprend au moins un peroxyde.

L'invention concerne également un dispositif comprenant au moins une couche à base d'au moins un matériau composite piézoélectrique défini ci-dessus et d'au moins deux électrodes disposées de part et d'autre de ladite couche.

Préférentiellement, les électrodes sont en métal.

Préférentiellement, le métal de l'électrode est choisi dans le groupe constitué par l'argent, l'or, le nickel, le palladium, l'aluminium, le cuivre, le titane et leur mélange, de préférence est l'or.

Préférentiellement selon un mode de réalisation, l'électrode est souple et est une couche E est une composition de caoutchouc conductrice à base d'au moins 50 pce d'élastomère diénique, d'un noir de carbone graphité ou partiellement graphité et d'un système de réticulation.

Un autre objet de la présente invention est un pneumatique comprenant au moins un dispositif piézoélectrique défini ci-dessus. Un autre objet de la présente invention est l'utilisation d'un matériau composite piézoélectrique défini ci-dessus pour la fabrication de pièces structurelles et de films supportés déposés sur tout ou partie de la surface d'un tel support.

Un autre objet de la présente invention concerne un procédé de fabrication de pièces structurelles et de films supportés dans lequel on dépose sur tout ou partie d'un support au moins un matériau composite piézoélectrique défini ci-dessus.

Le matériau composite de l'invention présente l'avantage d'avoir des propriétés piézoélectriques améliorées par rapport aux matériaux composites de l'art antérieur à iso conditions de polarisation. Ceci permet par exemple d'améliorer la viabilité du matériau composite ou bien d'utiliser des matériaux composites piézoélectriques de taille plus réduite pour délivrer la même intensité électrique, donc de diminuer des coût de production ou de miniaturiser les dispositifs dans lequel le matériau composite piézoélectrique est utilisé. Du fait de ces propriétés piézoélectriques améliorées, il est également possible de moduler l'étape de polarisation du matériau composite piézoélectrique de l'invention pour obtenir les mêmes propriétés qu'un matériau composite de l'art antérieur, par exemple en diminuant la durée de polarisation ou bien en diminuant la force électrique du champ électrique.

La figure 1 est une représentation du système d'axes orthogonaux pour la polarisation, P, et la contrainte. Les indices 1, 2, 3 correspondent respectivement aux directions normales aux plans YOZ, XOZ et XOY et les indices 4, 5, 6 aux directions tangentielles à ces mêmes plans.

L'invention concerne un matériau composite piézoélectrique à base d'une matrice polymérique et de charges inorganiques piézoélectriques, caractérisé en ce que ledit matériau comprend en outre au moins un liquide ionique de formule générale $Q^+A^-$, dans laquelle $Q^+$ représente un cation choisi parmi les cations ammoniums quaternaires et les cations phosphoniums quaternaires et $A^-$ représente tout anion susceptible de former un sel liquide à une température inférieure à 100°C.

Dans la présente description, tout intervalle de valeurs désigné par l'expression « de a à b » représente le domaine de valeurs allant de a jusqu'à b (c'est-à-dire bornes a et b inclues). Tout intervalle « entre a et b » représente le domaine de valeurs allant de plus de a à moins de b (c'est-à-dire bornes a et b exclues).

Par « matériau composite piézoélectrique », on entend un matériau à base d'au moins un matériau piézoélectrique qui confère au matériau composite son activité piézoélectrique, et à base d'une ou plusieurs phases non piézoélectriques. Cette association conduit à un matériau composite piézoélectrique dont les performances sont accrues par rapport à chaque phase seule.

Par l'expression « matériau composite piézoélectrique à base de », il faut entendre un matériau composite piézoélectrique comportant le mélange et/ou le produit de réaction in situ des différents constituants de base utilisés, certains de ces constituants pouvant réagir et/ou étant destinés à réagir entre eux, au moins partiellement, lors des différentes phases de fabrication dudit composite, ou le cas échéant lors de la cuisson ultérieure, modifiant ledit composite tel qu'il est préparé au départ. Ainsi les matériaux composites piézoélectriques tels que mis en œuvre pour l'invention peuvent être différents par exemple, le cas échéant à l'état non réticulé et à l'état réticulé.

L'expression « consiste essentiellement en » suivie d'une ou plusieurs caractéristiques, signifie que peuvent être inclus dans le procédé ou le matériau de l'invention, outre les composants ou étapes explicitement énumérés, des composants ou des étapes qui ne modifient pas significativement les propriétés et les caractéristiques de l'invention.

Les composés mentionnés dans la description et entrant dans la préparation de polymères ou de compositions de caoutchouc peuvent être d'origine fossile ou biosourcés. Dans ce dernier cas, ils peuvent être, partiellement ou totalement, issus de la biomasse ou obtenus à partir de matières premières renouvelables issues de la biomasse. Sont

concernés notamment les polymères, les charges....

Le matériau composite piézoélectrique de l'invention comprend une matrice polymérique, c'est-à-dire un polymère ou un mélange de polymères.

Par « matrice polymérique », on entend le polymère ou l'ensemble de polymères qui constitue la phase non piézoélectrique du matériau composite piézoélectrique.

Avantageusement, la matrice polymérique comprend au moins un polymère choisi dans le groupe constitué par les polymères thermodurcissables, les polymères thermoplastiques, les élastomères et les mélanges de ces polymères.

Avantageusement, la matrice du matériau composite piézoélectrique de l'invention, comprend au moins un élastomère thermoplastique et/ou un élastomère diénique.

Le choix de la nature du ou des polymères pour constituer la matrice dépendra de l'utilisation du dispositif dans lequel sera inséré le matériau composite piézoélectrique de l'invention. Par exemple, lorsque ce dispositif sera utilisé pour remplacer les batteries conventionnelles à durée limitée, on préférera utiliser une matrice polymérique rigide, donc par exemple, à base d'au moins un polymère thermodurcisseur ou bien d'un polymère thermoplastique. En revanche, lorsqu'on souhaite utiliser un dispositif dans un pneumatique, on préféra une matrice souple à base d'élastomères diéniques ou thermoplastiques, notamment diéniques.

Préférentiellement, les polymères thermodurcissables peuvent être choisis parmi les polyuréthanes, les résines phénol-formaldéhyde, les résines urée-formaldéhyde, les résines mélamine, les diallylphtalates, les résines époxy, les polyimides, et les résines polyesters. Parmi les polyuréthanes, on peut citer les polyuréthannes anioniques, cationiques, non-ioniques ou amphotères, les polyuréthannes-acryliques, les polyuréthannes-polyvinylpyrrolidones, les polyester-polyuréthannes, les polyétherpolyuréthannes, les polyurées, les polyurée/polyuréthannes, les polyuréthannes silicones, et leurs mélanges.

Préférentiellement, les polymères thermoplastiques utilisables dans le cadre de la présente invention peuvent être tout polymère, copolymère ou tout mélange de polymères et/ou copolymères ayant la propriété d'être thermoplastique. Parmi les polymères thermoplastiques, on peut notamment citer le polyéthylène basse densité (PEBD), le polypropylène (PP), le polystyrène (PS), le polyméthacrylate de méthyle (PMMA), les polyamides aliphatiques et les polyesters. Parmi les polyamides aliphatiques, on peut citer notamment les polyamides 4-6, 6, 6-6, 11 ou 12. Parmi les polyesters, on peut citer par exemple les PET (polyéthylène téréphthalate), PEN (polyéthylène naphthalate), PBT (polybutylène téréphthalate), PBN (polybutylène naphthalate), PPT (polypropylène téréphthalate), PPN (polypropylène naphthalate).

Parmi les polymères thermoplastiques utilisables dans le cadre de la présente invention, on peut aussi utiliser, préférentiellement, les élastomères thermoplastiques. Les élastomères thermoplastiques (en abrégé « TPE ») ont une structure intermédiaire entre polymères thermoplastiques et élastomères. Ce sont des copolymères à blocs, constitués de blocs rigides, thermoplastiques, reliés par des blocs souples, élastomères.

L'élastomère thermoplastique utilisé pour la mise en œuvre de l'invention peut être un copolymère à blocs dont la nature chimique des blocs thermoplastiques et des blocs élastomères peut varier.

De manière connue, les TPE présentent deux pics de température de transition vitreuse (Tg, mesurée selon ASTM D3418-1999), la température la plus basse étant relative à la partie élastomère du TPE, et la température la plus haute étant relative à la partie thermoplastique du TPE. Ainsi, les blocs souples des TPE se définissent par une Tg inférieure à la température ambiante (25°C), tandis que les blocs rigides ont une Tg supérieure à 80°C.

Pour être de nature à la fois élastomère et thermoplastique, le TPE doit être muni de blocs suffisamment incompatibles (c'est-à-dire différents du fait de leur masse, de leur polarité ou de leur Tg respectives) pour conserver leurs propriétés propres de bloc élastomère ou thermoplastique.

Les TPE peuvent être des copolymères avec un petit nombre de blocs (moins de 5, typiquement 2 ou 3), auquel cas ces blocs ont de préférence des masses élevées, supérieures à 15000 g/mol. Ces TPE peuvent être par exemple des copolymères diblocs, comprenant un bloc thermoplastique et un bloc élastomère. Ce sont souvent aussi des élastomères triblocs avec deux segments rigides reliés par un segment souple. Les segments rigides et souples peuvent être disposés linéairement, en étoile ou branchés. Typiquement, chacun de ces segments ou blocs contient souvent au minimum plus de 5, généralement plus de 10 unités de base (par exemple unités styrène et unités butadiène pour un copolymère blocs styrène/ butadiène/ styrène).

Les TPE peuvent aussi comprendre un grand nombre de blocs (plus de 30, typiquement de 50 à 500) plus petits, auquel cas ces blocs ont de préférence des masses peu élevées, par exemple de 500 à 5000 g/mol, ces TPE seront appelés TPE multiblocs par la suite, et sont un enchaînement blocs élastomères - blocs thermoplastiques.

Les blocs élastomères du TPE pour les besoins de l'invention, peuvent être tous les élastomères connus de l'homme de l'art. Ils possèdent de préférence une Tg inférieure à 25°C, préférentiellement inférieure à 10°C, plus préférentiellement inférieure à 0°C et très préférentiellement inférieure à -10°C. De manière préférentielle également, la Tg bloc élastomère du TPE est supérieure à -100°C.

On utilisera pour la définition des blocs thermoplastiques la caractéristique de température de transition vitreuse (Tg) du bloc rigide thermoplastique. Cette caractéristique est bien connue de l'homme du métier. Elle permet notamment

de choisir la température de mise en œuvre industrielle (transformation). Dans le cas d'un polymère (ou d'un bloc de polymère) amorphe, la température de mise en œuvre est choisie sensiblement supérieure à la Tg. Dans le cas spécifique d'un polymère (ou d'un bloc de polymère) semi-cristallin, on peut observer une température de fusion alors supérieure à la température de transition vitreuse. Dans ce cas, c'est plutôt la température de fusion (Tf) qui permet de choisir la température de mise en œuvre du polymère (ou bloc de polymère) considéré. Ainsi, par la suite, lorsqu'on parlera de « Tg (ou Tf, le cas échéant) », il faudra considérer qu'il s'agit de la température utilisée pour choisir la température de mise œuvre.

Pour les besoins de l'invention, les élastomères TPE comprennent un ou plusieurs bloc(s) thermoplastique(s) ayant de préférence une Tg (ou Tf, le cas échéant) supérieure ou égale à 80°C et constitué(s) à partir de monomères polymérisés. Préférentiellement, ce bloc thermoplastique a une Tg (ou Tf, le cas échéant) comprise dans un domaine variant de 80°C à 250°C. De préférence, la Tg (ou Tf, le cas échéant) de ce bloc thermoplastique est préférentiellement de 80°C à 200°C, plus préférentiellement de 80°C à 180°C.

La proportion des blocs thermoplastiques par rapport au TPE, tel que défini pour la mise en œuvre de l'invention, est déterminée d'une part par les propriétés de thermoplasticité que doit présenter ledit copolymère. Les blocs thermoplastiques ayant une Tg (ou Tf, le cas échéant) supérieure ou égale à 80°C sont préférentiellement présents dans des proportions suffisantes pour préserver le caractère thermoplastique de l'élastomère selon l'invention. Le taux minimum de blocs thermoplastiques ayant une Tg (ou Tf, le cas échéant) supérieure ou égale à 80°C dans le TPE peut varier en fonction des conditions d'utilisation du copolymère. D'autre part, la capacité du TPE à se déformer peut également contribuer à déterminer la proportion des blocs thermoplastiques ayant une Tg (ou Tf, le cas échéant) supérieure ou égale à 80°C.

A titre d'exemple, on peut utiliser pour la matrice polymérique du matériau piézoélectrique de l'invention tout TPE qui est un copolymère dont la partie élastomère est saturée, et comportant des blocs styrènes et des blocs alkylènes. Les blocs alkylènes sont préférentiellement de l'éthylène, du propylène ou du butylène. Plus préférentiellement, cet élastomère TPE est choisi dans le groupe suivant, constitué par les copolymères diblocs, les copolymères triblocs linéaires ou étoilés : styrène/ éthylène/ butylène (SEB), styrène/ éthylène/ propylène (SEP), styrène/ éthylène/ éthylène/ propylène (SEEP), styrène/ éthylène/ butylène/ styrène (SEBS), styrène/ éthylène/ propylène/ styrène (SEPS), styrène/ éthylène/ éthylène/ propylène/ styrène (SEEPS), styrène/ isobutylène (SIB), styrène/ isobutylène/ styrène (SIBS) et les mélanges de ces copolymères.

Selon un autre exemple, on peut utiliser pour la matrice polymérique du matériau piézoélectrique de l'invention tout TPE qui est un copolymère dont la partie élastomère est insaturée, et qui comporte des blocs styrènes et des blocs diènes, ces blocs diènes étant en particulier des blocs isoprène ou butadiène. Plus préférentiellement, cet élastomère TPE est choisi dans le groupe suivant, constitué par les copolymères diblocs, les copolymères triblocs linéaires ou étoilés : styrène/ butadiène (SB), styrène/ isoprène (SI), styrène/ butadiène/ isoprène (SBI), styrène/ butadiène/ styrène (SBS), styrène/ isoprène/ styrène (SIS), styrène/ butadiène/ isoprène/ styrène (SBIS) et les mélanges de ces copolymères.

Par exemple également, le TPE utilisé peut-être un copolymère linéaire ou étoilé dont la partie élastomère comporte une partie saturée et une partie insaturée comme par exemple le styrène/ butadiène/ butylène (SBB), le styrène/ butadiène/ butylène/ styrène (SBBS) ou un mélange de ces copolymères.

Parmi les TPE multiblocs, on peut utiliser les copolymères comportant des blocs copolymère statistique d'éthylène et de propylène/ polypropylène, polybutadiène/ polyuréthane (TPU), polyéther/ polyester (COPE), polyéther/ polyamide (PEBA).

Il est également possible que les TPE donnés en exemple ci-dessus soient mélangés entre eux au sein de la matrice TPE selon l'invention.

A titre d'exemples d'élastomères TPE commercialement disponibles, on peut citer les élastomères de type SEPS, SEEPS, ou SEBS commercialisés par la société Kraton sous la dénomination « Kraton G » (produits « G1650, G1651, G1654, G1730 ») ou la société Kuraray sous la dénomination «Septon» (« Septon 2007 », « Septon 4033 », « Septon 8004 ») ; ou les élastomères de type SIS commercialisés par Kuraray, sous le nom « Hybrar 5125 », ou commercialisés par Kraton sous le nom de « D1161 » ou encore les élastomères de type SBS linéaire commercialisé par Polimeri Europa sous la dénomination « Europrene SOL T 166 » ou SBS étoilé commercialisés par Kraton sous la dénomination « D1184 ». On peut également citer les élastomères commercialisés par la société Dexco Polymers sous la dénomination de « Vector » (« Vector 4114 », « Vector 8508 »). Parmi les TPE multiblocs, on peut citer le TPE « Vistamaxx » commercialisé par la société Exxon ; le TPE COPE commercialisé par la société DSM sous le dénomination « Arnitel », ou par la société Dupont sous le dénomination « Hytrel », ou par la société Ticona sous le dénomination « Riteflex » ; le TPE PEBA commercialisé par la société Arkéma sous le dénomination « PEBAX » ; le TPE TPU commercialisé par la société Sartomer sous le dénomination « TPU 7840 », ou par la société BASF sous le dénomination « Elastogran ».

Préférentiellement, la matrice polymérique comprend au moins un élastomère diénique.

Par « élastomère (ou indistinctement caoutchouc) diénique », qu'il soit naturel ou synthétique, doit être compris de manière connue un élastomère constitué au moins en partie (i.e., un homopolymère ou un copolymère) d'unités monomères diènes (monomères porteurs de deux doubles liaisons carbone-carbone, conjuguées ou non).

Ces élastomères diéniques peuvent être classés dans deux catégories : « essentiellement insaturés » ou « essentiellement saturés ». On entend en général par « essentiellement insaturé », un élastomère diénique issu au moins en partie de monomères diènes conjugués, ayant un taux de motifs ou unités d'origine diénique (diènes conjugués) qui est supérieur à 15% (% en moles); c'est ainsi que des élastomères diéniques tels que les caoutchoucs butyle ou les copolymères de diènes et d'alpha-oléfines type EPDM n'entrent pas dans la définition précédente et peuvent être notamment qualifiés d'élastomères diéniques « essentiellement saturés » (taux de motifs d'origine diénique faible ou très faible, toujours inférieur à 15% en moles).

A titre d'élastomère diénique susceptible d'être utilisé dans les matrices polymériques du matériau composite piézoélectrique conforme à l'invention conviennent :

- tout homopolymère d'un monomère diène, conjugué ou non, ayant de 4 à 18 atomes de carbone ;
- tout copolymère d'un diène, conjugué ou non, ayant de 4 à 18 atomes de carbone et d'au moins un autre monomère.

L'autre monomère du copolymère d'un diène peut être l'éthylène, une oléfine ou un diène, conjugué ou non.

A titre de diènes conjugués conviennent les diènes conjugués ayant de 4 à 12 atomes de carbone, en particulier les 1,3-diènes, tels que notamment le 1,3-butadiène et l'isoprène.

A titre de diènes non conjugués conviennent les diènes non conjugués ayant de 6 à 12 atomes de carbone, tels que le 1,4-hexadiène, l'éthylidène norbornène, le dicyclopentadiène.

A titre d'oléfines conviennent les composés vinylaromatiques ayant de 8 à 20 atomes de carbone et les $\alpha$-monooléfines aliphatiques ayant de 3 à 12 atomes de carbone.

A titre de composés vinylaromatiques conviennent par exemple le styrène, l'ortho-, méta-, para-méthylstyrène, le mélange commercial « vinyle-toluène », le para-tertiobutylstyrène.

A titre d'$\alpha$-monooléfines aliphatiques conviennent notamment les $\alpha$-monooléfines aliphatiques acycliques ayant de 3 à 18 atomes de carbone.

Plus particulièrement, l'élastomère diénique est :

- tout homopolymère d'un monomère diène conjugué, notamment tout homopolymère obtenu par polymérisation d'un monomère diène conjugué ayant de 4 à 12 atomes de carbone;
- tout copolymère obtenu par copolymérisation d'un ou plusieurs diènes conjugués entre eux ou avec un ou plusieurs composés vinylaromatiques ayant de 8 à 20 atomes de carbone;
- tout copolymère obtenu par copolymérisation d'un ou plusieurs diènes, conjugués ou non, avec l'éthylène, une $\alpha$-monooléfine ou leur mélange comme par exemple les élastomères obtenus à partir d'éthylène, de propylène avec un monomère diène non conjugué du type précité.

Préférentiellement, l'élastomère diénique est choisi dans le groupe constitué par le caoutchouc naturel (NR), les copolymères de diènes et d'alpha-oléfines, les polyisoprènes de synthèse (IR), les polybutadiènes (BR), les copolymères de butadiène, les copolymères d'isoprène et les mélanges de ces élastomères diéniques. Parmi les copolymères d'isoprène, on citera en particulier les copolymères d'isobutène-isoprène (caoutchouc butyle - IIR), d'isoprène-styrène (SIR), d'isoprène-butadiène (BIR) ou d'isoprène-butadiène-styrène (SBIR). Parmi les copolymères du butadiène, on citera en particulier les copolymères de butadiène-styrène (SBR), d'isoprène-butadiène (BIR) ou d'isoprène-butadiène-styrène (SBIR). Parmi les copolymères de diènes et d'alpha-oléfines, les copolymères d'éthylène-propylène-monomère diénique (EPDM) sont les préférés.

Plus préférentiellement encore, l'élastomère diénique est choisi dans le groupe constitué pat le caoutchouc naturel, les copolymères éthylène-propylène-diène monomère, les polyisoprènes de synthèse, les polybutadiènes, les copolymères de styrène-butadiène, les copolymères d'isoprène-styrène, les copolymères d'isoprène-butadiène-styrène, les copolymères d'isoprène-butadiène et les mélanges de ces élastomères diéniques.

Plus préférentiellement encore, l'élastomère diénique est un copolymère de styrène-butadiène. Conviennent en particulier, les copolymères de butadiène-styrène et en particulier ceux ayant une Tg (température de transition vitreuse (Tg, mesurée selon ASTM D3418-1999) comprise entre 0°C et - 90°C et plus particulièrement entre - 10°C et - 70°C, une teneur en styrène comprise entre 1% et 60% en poids et plus particulièrement entre 20% et 50%, une teneur (% molaire) en liaisons -1,2 de la partie butadiénique comprise entre 4% et 75%, une teneur (% molaire) en liaisons trans-1,4 comprise entre 10% et 80%.

L'élastomère diénique peut être modifié, c'est à dire soit couplé et/ou étoilé, soit fonctionnalisé, soit couplé et/ou étoilé et simultanément fonctionnalisé.

Ainsi, l'élastomère diénique peut être couplé et/ou étoilé, par exemple au moyen d'un atome silicium ou d'étain qui lie entre elles les chaînes élastomères.

L'élastomère diénique peut être simultanément ou alternativement fonctionnalisé et comprendre au moins groupe fonctionnel. Par groupe fonctionnel, on entend un groupe comprenant au moins un hétéroatome choisi parmi Si, N,

S, O, P. Conviennent particulièrement à titre de groupes fonctionnels ceux comprenant au moins une fonction telle que : le silanol, un alcoxysilane, une amine primaire, secondaire ou tertiaire, cyclique ou non, un thiol, un époxyde.

Dans le cadre des élastomères fonctionnalisés, c'est-à-dire comprenant au moins un groupe fonctionnel :

- Le groupe fonctionnel peut se situer en extrémité de chaîne élastomère, on dira alors que l'élastomère diénique est fonctionnalisé en bout ou extrémité de chaîne.
- Le groupe fonctionnel peut se situer dans la chaîne élastomère principale linéaire, on dira alors que l'élastomère diénique est couplé ou encore fonctionnalisé en milieu de chaîne, par opposition à la position "en bout de chaîne" et bien que le groupement ne se situe pas précisément au milieu de la chaîne élastomère principale.
- Le groupe fonctionnel peut être central et lier n chaînes élastomères (n>2), l'élastomère étant étoilé ou branché.

L'élastomère diénique peut comporter plusieurs groupes fonctionnels, pendants ou non, répartis le long de la chaîne principale de l'élastomère, on dira alors que l'élastomère diénique est fonctionnalisé le long de la chaîne.

La matrice polymérique peut contenir un seul élastomère, notamment diénique ou un mélange de plusieurs élastomères, notamment diéniques et/ou thermoplastiques.

Selon un mode de réalisation de l'invention, si plusieurs polymères sont utilisés dans la matrice polymérique du matériau composite piézoélectrique de l'invention, le ou les élastomères diéniques constituent la fraction majoritaire en poids ; ils représentent alors plus de 50% en poids, plus préférentiellement au moins 75% en poids par rapport au poids total des polymères dans la composition de caoutchouc. De manière préférentielle également, le ou les élastomères diéniques représentent au moins 90%, voire 95% (en particulier 100%) en poids par rapport au poids total des polymères dans la composition de caoutchouc.

Préférentiellement, la matrice polymérique comprend de 75 à 100 partie en poids d'élastomère diénique par rapport à 100 parties en poids de polymères, plus avantageusement de 90 à 100 partie en poids d'élastomère diénique par rapport à 100 parties en poids de polymères, encore plus avantageusement de 95 à 100 partie en poids d'élastomère diénique par rapport à 100 parties en poids de polymères. Dans une variante préférée de l'invention, l'élastomère diénique, ou le mélange d'élastomères diéniques, est le seul élastomère de la matrice polymérique.

Le matériau composite piézoélectrique de l'invention est également à base d'au moins une charge inorganique piézoélectrique. Ces charges inorganiques piézoélectriques peuvent être avantageusement dispersées dans la matrice polymérique, avantageusement sous forme de particules non liées à la matrice polymérique.

Par « particules non liées à la matrice polymérique », on entend des particules sans liaisons covalentes entre la charge inorganique piézoélectrique et au(x) polymère(s) constitutif(s) de la matrice polymérique du matériau composite piézoélectrique.

Par « particules dispersées dans la matrice polymérique », on entend que la charge inorganique piézoélectrique utilisée dans le cadre de la présente invention est répartie de façon sensiblement uniforme dans la matrice polymérique du matériau composite piézoélectrique. Ainsi, la distance moyenne séparant les particules de ces charges adjacentes est sensiblement constante dans la totalité du volume de ladite matrice polymérique.

Ces charges inorganiques piézoélectriques peuvent être des monocristaux piézoélectriques ou des céramiques piézoélectriques.

Les monocristaux piézoélectriques sont notamment des matériaux piézoélectriques naturels comme le quartz ou la tourmaline. Ces cristaux, ferroélectriques, peuvent posséder une structure en domaines. On peut distinguer les monocristaux monodomaines et monocristaux polydomaines selon qu'une ou plusieurs directions de polarisation coexistent dans le cristal.

Avantageusement, la charge inorganique piézoélectrique utilisée dans le cadre de l'invention peut être choisie parmi les céramiques piézoélectriques.

Les céramiques piézoélectriques sont des matériaux à fort couplage électromécanique et haute densité. Ces céramiques tirent leur propriété piézoélectrique de leur structure cristalline, à travers l'absence de symétrie de la maille cristalline qui dissocie les centres de gravité des charges positives et négatives, chaque maille constituant alors un dipôle électrique. La maille cristalline possède ainsi un dipôle permanent qui confère à ces céramiques des valeurs de permittivité diélectrique élevées. Les céramiques piézoélectriques de synthèse sont en particulier composées d'oxydes ferroélectriques, qui ont pour propriété de posséder une polarisation électrique à l'état spontané, qui peut en outre être renversée par l'application d'un champ électrique extérieur suffisamment intense.

Avantageusement, la charge inorganique piézoélectrique peut être choisie parmi les oxydes ferroélectriques.

Les oxydes ferroélectriques peuvent notamment être dotés d'une structure pérovskite. Ils répondent avantageusement à une formule générale $ABO_3$ tels que le titanate de baryum ($BaTiO_3$), le titanate de plomb ($PbTiO_3$), le niobate de potassium ($KNbO_3$), le niobate de plomb ($PbNbO_3$), ou le ferrite de bismuth ($BiFeO_3$). Dans cette famille de matériaux piézoélectriques, on peut également citer le titano-zirconate de plomb (PZT) avec une structure $Pb(Zr_xTi_{1-x})O_3$ dans laquelle x est compris entre 0 et 1. Il peut être sous forme pure ou sous forme de semiconducteur dopé soit avec des dopants accepteurs (pour donner un PZT dit dur ou « hard »), tels que Fe, Co, Mn, Mg, Al, In, Cr, Sc, Na ou K, soit avec des

dopants donneurs (pour donner un PZT dit doux ou soft), tels que La, Nd, Sb, Ta, Nb ou W.

Avantageusement, les charges inorganiques piézoélectriques utilisables dans le cadre de l'invention ont une structure pérovskite.

A titre d'exemples non limitatifs, la charge inorganique piézoélectrique utilisable dans le cadre de l'invention peut être choisie dans le groupe constitué par le titanate de baryum, le titanate de plomb, le titano-zirconate de plomb (PZT), le niobate de plomb, le niobate de lithium, le niobate de potassium et leurs mélanges.

Les céramiques piézoélectriques les plus connues sont le titanate de baryum ($BaTiO_3$) et le titanate zirconate de plomb (PZT), qui ont un très bon coefficient électromécanique et présentent des procédés de fabrication variés. Ces derniers (procédé sol-gel, synthèse hydrothermale, calcination, ...) permettent de modifier les propriétés diélectrique, mécanique et piézoélectrique en fonction de l'application visée. Le titanate de baryum, tout comme le niobate de potassium sont des matériaux piézoélectriques sans plomb. Ils ont l'avantage d'être moins toxiques.

Avantageusement, la charge inorganique piézoélectrique peut être choisie parmi le titanate de baryum, le niobate de potassium, le titano-zirconate de plomb et leurs mélanges. Plus préférentiellement encore, la charge inorganique piézoélectrique est choisie parmi le titanate de baryum, le niobate de potassium et leurs mélanges.

En particulier, les charges inorganiques piézoélectriques ont des tailles de particules comprises entre 50 nm et 800 $\mu$m. La taille des particules correspond au diamètre moyen des particules. La mesure du diamètre moyen est réalisée par analyse microscopique électronique à balayage (MEB). Des clichés sont réalisés sur des échantillons de poudre. Une analyse d'image est réalisée à l'aide d'un logiciel et permet d'accéder au diamètre moyen des particules présentes.

Le volume de charges inorganiques piézoélectriques utilisées dans le matériau de l'invention dépendra de l'utilisation dudit matériau.

Préférentiellement, le taux de charge inorganique piézoélectrique dans le matériau composite de l'invention est supérieur ou égal à 5 % en volume, en particulier supérieur ou égal à 6 % en volume, plus préférentiellement encore supérieur ou égal à 7 % en volume par rapport au volume total du matériau composite piézoélectrique.

Plus préférentiellement encore, le taux de charge inorganique piézoélectrique est compris dans un domaine allant de de 5 % à 80 % en volume par rapport au volume total du matériau composite piézoélectrique, avantageusement dans un domaine de 6 % à 60 % en volume, plus avantageusement encore de 7 % à 50 % en volume.

Le matériau composite piézoélectrique de l'invention comprend au moins un liquide ionique.

Par « liquide ionique », on entend au sens de la présente invention, un solvant ionisé non aqueux qui est liquide à une température inférieure à 100°C, c'est-à-dire une substance liquide non-aqueuse pour une température inférieure à 100°C (à pression atmosphérique) caractérisée par une dissociation des espèces neutres en divers cations et anions.

Les liquides ioniques (appelés « Room Temperature Ionic Liquide» ou « RTIL » en anglais) sont donc des sels non-aqueux fondus fortement ionisés et qui présentent notamment une température de fusion inférieure ou égale à 150°C, de préférence inférieure à 100°C. La température de fusion est mesurée par analyse calorimétrique différentielle, avec une vitesse de montée en température de 10°C/minute, la température de fusion est alors à une température correspondant au sommet du pic endotherme de fusion obtenu lors de la mesure.

Les liquides ioniques ne doivent pas être confondus avec des sels, type NaCl, $NH_4Cl$, $MgSO_4$ etc... qui sont souvent solide à température ambiante et se dissolvent dans un solvant, notamment dans un solvant aqueux tel que l'eau. Les liquides ioniques ont été décrits plus en détail dans les documents suivants : « Ionic Liquids, Physicochemical properties », Suojiang Zhang Xingmei Lu Qing Zhou Xiaohua Li Xiangping Zhang Shucai Li, Elsevier Science (2009) ; « Ionic liquids "in a nutshell'' (history, properties and development) », Pernak J., Rzemieniecki T., Materna K.,CHEMIK, 70 (9) 471-480 (2016) ; et dans « An Introduction to Ionic Liquids », Freemantle, M., Royal Society of Chemistry; 1st edition (2010).

Le liquide ionique peut donc être issu de l'association d'un anion minéral ou organique et d'un cation minéral ou organique. De préférence, une molécule organique constitue le cation du liquide ionique et l'anion du liquide ionique peut être minéral ou organique.

Le liquide ionique utilisé dans le cadre de la présente invention est un liquide ionique de formule générale $Q^+A^-$, dans laquelle $Q^+$ représente un cation choisi parmi les cations ammoniums quaternaires les cations phosphoniums quaternaires et $A^-$ représente tout anion susceptible de former un sel liquide à une température inférieure ou égale à 100°C, et avantageusement inférieure à ou égale à 85°C, plus préférentiellement encore inférieure à égale à 50°C.

Les cations ammoniums quaternaires et les cations phosphoniums quaternaires Q+ répondent de préférence aux formules générales $N^+R^aR^bR^cR^d$ et $P^+R^aR^bR^cR^d$, ou aux formules générales $R^aR^bN^+{=}CR^cR^d$ et $R^aR^bP^+{=}CR^cR^d$ où $R^a$, $R^b$, $R^c$ et $R^d$, identiques ou différents, représentent un atome d'hydrogène (à l'exception du cation $NH4^+$ pour $N^+R^aR^bR^cR^d$, de préférence un seul substituant de $R^a$, $R^b$, $R^c$ et $R^d$ représente l'hydrogène), ou des radicaux hydrocarbyles ayant de 1 à 30 atomes de carbone. Ces radicaux hydrocarbyles peuvent être par exemples des alkyles en C1-C30, saturés ou non saturés, des cycloalkyles en C3-C30, des cycles aromatiques en C5-C30. Ces radicaux hydrocarbyles peuvent être substitués ou non.

Les substituants $R^a$, $R^b$, $R^c$ et $R^d$ peuvent aussi former un cycle hétérocycles azotés et/ou phosphorés comportant 1, 2 ou 3 atomes d'azote et/ou de phosphore, de formules générales

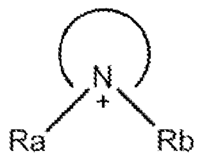
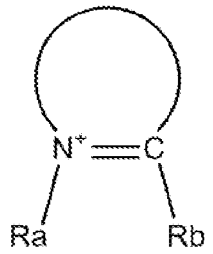
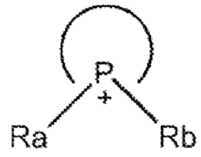
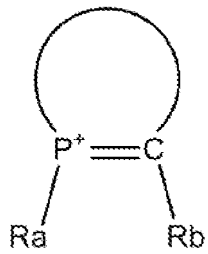

dans lesquelles les cycles sont constitués de 4 à 10 atomes, de préférence de 5 à 6 atomes, $R^a$ et $R^b$ sont définis comme précédemment.

Préférentiellement, le ou les liquides ioniques utilisés dans le cadre de la présente invention possède un cation Q+ ammonium quartenaire choisi dans le groupe constitué par les cations imidazolium, les cations pyrazolium, les cations pyridinium, les cations pyrimidinium, les cations tétra-alkyl(C1-C6)ammonium, les cations guanidium et les cations pyrrolidium.

Les cations imidazoliums répondent préférentiellement à la formule générale (I) suivante

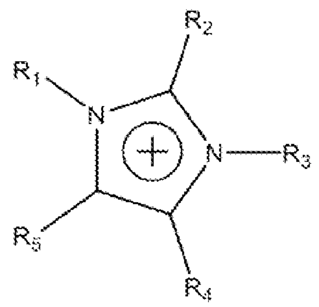

(I)

dans laquelle:

- R1 représente un groupe alkyle comportant de 1 à 15 atomes de carbone, de préférence de 1 à 10 atomes de carbone, éventuellement substitué par un ou plusieurs groupements aryles en C6-C30, thiols, hydroxy ou interrompu par un ou plusieurs atomes d'oxygène ou de soufre ou par un ou plusieurs groupements NR',
- R2, R3, R4, R5 et R', identiques ou différents, représentent chacun un atome d'hydrogène ou un groupe alkyle comportant de 1 à 10 atomes de carbone, de préférence de 1 à 5 atomes de carbone, ou un groupe aryle en C6-C30, éventuellement substitué par un ou plusieurs groupes alkyles en C1-C4.

Plus préférentiellement encore, dans la formule (I), R1 représente un groupe alkyle comportant de 1 à 10 atomes de carbone et R2, R3, R4, et R5, identiques ou différents, représentent chacun un atome d'hydrogène ou un groupe alkyle comportant de 1 à 10 atomes de carbone, de préférence de 1 à 5 atomes de carbone.

Plus préférentiellement encore, dans la formule (I), R1 représente un groupe alkyle comportant de 1 à 10 atomes de carbone ; R2 et R3, identiques ou différents, représentent chacun un atome d'hydrogène ou un groupe alkyle comportant de 1 à 10 atomes de carbone, de préférence de 1 à 5 atomes de carbone ; R4 et R5 représentent un atome d'hydrogène.

Les cations imidazoliums de formule générale (I), plus particulièrement préférés, sont choisis parmi le 1-éthyle-3-méthylimidazolium, le 1-butyl-3-méthylimidazolium, le 1-héxyl-m-méthylimidazolium, le 1-octyl-3-méthylimidazolium, le 1-décyl-3-méthylimidazolium, le 1,3-dibutylimidazolium et le 1-butyl-2,3-diméthylimidazolium.

Le ou les liquides ioniques possèdent un anion $A^-$ susceptible de former un sel liquide à une température inférieure ou égale à 100°C, et avantageusement inférieure à ou égale à 85°C, plus préférentiellement encore inférieure à égale à 50°C. Cet anion peut être un anion minéral ou un anion organique.

Plus préférentiellement, l'anion $A^-$ peut être choisi dans le groupe constitué par les anions chlorure ($Cl^-$), les anions bromure ($Br^-$), les anions tétrachloroaluminate ($AlCl_4^-$), les anions tétrachloronickel ($NiCl_4^-$), les anions perchlorate ($ClO_4^-$), les anions nitrate ($NO_3^-$), les anions nitrite ($NO_2^-$), les anions sulfate ($SO_4^-$), les anions méthylsulfate ($CH_3SO4^-$), les anions tétrafluoroborate ($BF_4^-$), les anions phosphate ($PO_4^{3-}$), les anions hexafluorophosphate ($PF_6^-$), les anions dibutylphosphate et les anions tris (pentafluoroéthyl)trifluorophosphate, les anions hexafluoroantimonate ($SbF_6^-$), les

anions triflate [NfO] ($CF_3SO_2^-$), les anions nonaflate [NfO] ($CF_3(CF_2)_3SO_2^-$), les anions bis(trifyl)amide [Tf2N] ($(CF_3SO_2)_2N^-$), les anions trifluoroacétate [TA] ($CF_3CO_2^-$), heptafluorobutanoate [HB] ($CF_3(CF_2)_3CO_2^-$), les anions acétate ($CH_3CO_2^-$), les anions trifluoroacétate ($CF_3CO_2^-$), les anions trifluorométhanesulfonate ($CF_3SO_3^-$), les anions dicyanamide, les anions hydroxyde ($OH^-$), les anions salicylate, les anions L-(+)lactate, les anions propionate ($CH_3CH_2CO_2^-$) et les anions pentafluorométhanesulfonate.

Plus préférentiellement encore, l'anion $A^-$ est choisi dans le groupe constitué par l'acétate, le trifluoroacétate, le propionate, le chlorure, l'hydroxyle, le sulfate, le trifluorométhanesulfonate, le pentafluorométhanesulfonate et les phosphates ; de préférence l'anion $A^-$ est l'acétate ou le propionate.

Plus préférentiellement encore, le liquide ionique est de formule $Q^+A^-$ dans lequel $Q^+$ est choisi dans le groupe constitué par les cations imidazolium, les cations pyrazolium, les cations pyridinium, les cations pyrimidinium, les cations tétra-alkyl(C1-C6)ammonium, les cations guanidium et les cations pyrrolidium et $A^-$ est choisi dans le groupe formé par l'acétate, le trifluoroacétate, le propionate, le chlorure, l'hydroxyle, le sulfate, le trifluorométhanesulfonate, le pentafluorométhanesulfonate et les phosphates.

Plus préférentiellement encore, le liquide ionique est de formule $Q^+A^-$ dans lequel $Q^+$ est choisi parmi les cations imidazolium, de préférence les cations imidazolium de formule (I) et $A^-$ est choisi dans le groupe formé par l'acétate, le trifluoroacétate et le propionate.

De manière non exhaustive, le ou les liquides ioniques utilisés selon l'invention peuvent être choisis parmi les composés suivants : le chlorure de 1-éthyl-3-méthylimidazolium, le bromure de 1-éthyl-3-méthylimidazolium, le chlorure de 1-butyl-3-méthylimidazolium, le chlorure de 1-hexyl-3-méthylimidazolium, le chlorure de 1-méthyl-3-octylimidazolium, le chlorure de 1-décyl-3-méthylimidazolium, le bromure de 1-décyl-3-méthylimidazolium, le chlorure de 1-dodécyl-3-méthylimidazolium, le chlorure de 1-méthyl-3-tétradécylimidazolium, le tétrafluoroborate de 1-éthyl-3-méthylimidazolium, le tétrafluoroborate de 1-butyl-3-méthylimidazolium, le tétrafluoroborate de 1-pentyl-3-méthylimidazolium, le tétrafluoroborate de 1-hexyl-3-méthylimidazolium, le tétrafluoroborate de 1-heptyl-3-méthylimidazolium, le tétrafluoroborate de 1-octyl-3-méthylimidazolium, le tétrafluoroborate de 1-nonyl-3-méthylimidazolium, le tétrafluoroborate de 1-décyl-3-méthylimidazolium, le tétrafluoroborate de 1-hexyl-3-éthylimidazolium, l'hexafluorophosphate de 1-éthyl-3-méthylimidazolium, l'hexafluorophosphate de -butyl-3-méthylimidazolium, l'hexafluorophosphate de 1-pentyl-3-méthylimidazolium, l'hexafluorophosphate de 1-hexyl-3-méthylimidazolium, l'hexafluorophosphate de 1-heptyl-3-méthylimidazolium, l'hexafluorophosphate de 1-octyl-3-méthylimidazolium, l'hexafluorophosphate de 1-nonyl-3-méthylimidazolium, l'hexafluorophosphate de 1-décyl-3-méthylimidazolium, le méthylsulfate de 1,3-diméthylimidazolium, le méthylsulfate de 1-méthyl-3-butylimidazolium, le nitrate de 1-éthyl-3-méthylimidazolium, le nitrite de 1-éthyl-3-méthylimidazolium, l'acétate de 1-éthyl-3-méthylimidazolium, le sulfate de 1-éthyl-3-méthylimidazolium, les triflates de 1-éthyl-3méthylimidazolium, les nonaflates de 1-éthyl-3-méthylimidazolium, le bis(trifyl)amide de 1-éthyl-3-méthylimidazolium, le chlorure de trihexyl-tétradécyl-phosphonium, le chlorure de tributyl-tétradécyl-phosphonium, le trifluoroacétate de 1-éthyl-3-méthylimidazolium. le chlorure de 1-hexyl-2,3-diméthylimidazolium, le chlorure de 1-éthyl-2,3-diméthylimidazolium, le dicyanamide de 1-éthyl-3-méthylimidazolium, le 1-butyl-3-méthylimidazolium dicyanamide, le méthylphosphonate de 1-éthyl-3-méthylimidazolium et l'acétate de 1- butyl-3-méthylimidazolium.

Plus préférentiellement encore, le liquide ionique est de formule $Q^+A^-$ dans lequel $Q^+$ est choisi dans le groupe formé par le 1-éthyle-3-méthylimidazolium, le 1-butyl-3-méthylimidazolium, le 1-héxyl-m-méthylimidazolium, le 1-octyl-3-méthylimidazolium, le 1-décyl-3-méthylimidazolium, le 1,3-dibutylimidazolium et le 1-butyl-2,3-diméthylimidazolium et $A^-$ est choisi dans le groupe formé par l'acétate, le trifluoroacétate, le propionate, le chlorure, l'hydroxyle, le sulfate, le trifluorométhanesulfonate, le pentafluorométhanesulfonate et les phosphates.

Plus préférentiellement encore, le liquide ionique est choisi dans le trifluoroacétate de 1-éthyl-3-méthylimidazolium, l'acétate de 1- butyl-3-méthylimidazolium, l'acétate de 1-éthyl-3-méthylimidazolium, trifluoroacétate de 1- butyl-3-méthylimidazolium.

L'homme du métier sait adapter le taux de liquide ionique dans le matériau composite piézoélectrique de l'invention en fonction de la force électrique du champ électrique utilisé lors de la phase de polarisation dudit matériau composite.

Préférentiellement, le taux de liquide ionique dans le matériau composite piézoélectrique est supérieur ou égal à 0,1 parties en poids pour cent partie en poids de polymère, de préférence est compris dans un domaine allant de 0,1 à 15 parties en poids pour cent partie en poids de polymère, plus préférentiellement de 0,5 à 12 parties en poids pour cent partie en poids de polymère, plus préférentiellement encore de 1 à 10 parties en poids pour cent partie en poids de polymère.

Les liquides ioniques sont disponibles commercialement auprès de fournisseurs tels que Sigma-Aldrich.

Lorsque la matrice polymérique comprend au moins un élastomère, notamment thermoplastique et/ou diénique, le système de réticulation peut être tout type de système connu. Il peut notamment être à base de soufre, et/ou de peroxyde et/ou de bismaléimides.

Selon un mode de réalisation préférentiel, le système de réticulation est à base de soufre, on parle alors d'un système de vulcanisation. Le soufre peut être apporté sous toute forme, notamment sous forme de soufre moléculaire, ou d'un agent donneur de soufre. Au moins un accélérateur de vulcanisation est également préférentiellement présent, et, de

manière optionnelle, préférentielle également, on peut utiliser divers activateurs de vulcanisation connus tels que l'oxyde de zinc, l'acide stéarique ou tout composé équivalent tels que les sels d'acide stéarique et sels de métaux de transition, les dérivés guanidiques (en particulier diphénylguanidine), ou encore des retardateurs de vulcanisation connus.

Lorsqu'il est présent, le soufre est utilisé à un taux préférentiel compris entre 0,5 et 12 partie en poids pour cent parties en poids de polymère, en particulier entre 1 et 10 partie en poids pour cent parties en poids de polymère. L'accélérateur de vulcanisation est utilisé à un taux préférentiel compris entre 0,5 et 10 partie en poids pour cent parties en poids de polymère, plus préférentiellement compris entre 0,5 et 5,0 partie en poids pour cent parties en poids de polymère.

On peut utiliser comme accélérateur tout composé susceptible d'agir comme accélérateur de vulcanisation des élastomères diéniques en présence de soufre, notamment des accélérateurs du type thiazoles ainsi que leurs dérivés, des accélérateurs de types sulfénamides, thiurames, dithiocarbamates, dithiophosphates, thiourées et xanthates. A titre d'exemples de tels accélérateurs, on peut citer notamment les composés suivants : disulfure de 2-mercaptobenzothiazyle (en abrégé « MBTS »), N-cyclohexyl-2-benzothiazyle sulfénamide (« CBS »), N,N-dicyclohexyl-2-benzothiazyle sulfénamide (« DCBS »), N-ter-butyl-2-benzothiazyle sulfénamide (« TBBS »), N-ter-butyl-2-benzothiazyle sulfénimide (« TBSI »), disulfure de tétrabenzylthiurame (« TBZTD »), dibenzyldithiocarbamate de zinc (« ZBEC ») et les mélanges de ces composés.

Selon un autre mode de réalisation préférentiel, le système de réticulation contient préférentiellement un peroxyde. Avantageusement, le peroxyde est le seul agent de réticulation. Ainsi, avantageusement, selon ce mode de réalisation la composition ne comprend pas de système de vulcanisation, c'est-à-dire de système de réticulation à base de soufre.

Le peroxyde utilisable dans le cadre de l'invention peut être tout peroxyde connu de l'homme de l'art.

De manière préférée, le peroxyde est choisi parmi les peroxydes organiques.

Par « peroxyde organique », on entend un composé organique, c'est-à-dire contenant du carbone, comportant un groupe -O-O- (deux atomes d'oxygène liés par une liaison covalente simple).

Durant le procédé de réticulation, le peroxyde organique se décompose au niveau de sa liaison instable O-O en radicaux libres. Ces radicaux libres permettent la création des liaisons de réticulation.

Selon un mode de réalisation, le peroxyde organique est choisi dans le groupe constitué par les peroxydes de dialkyle, les monoperoxycarbonates, les peroxydes de diacyle, les peroxycétales les peroxyesters et leurs mélanges.

De préférence, les peroxydes de dialkyle sont choisis dans le groupe constitué par le peroxyde de dicumyle, le peroxyde de di-t-butyle, peroxyde de t-butylcumyle , le 2,5-diméthyl-2,5-di(t-butylperoxy)hexane, le 2,5-diméthyl-2,5-di(t-amylperoxy)-hexane, le 2,5-diméthyl-2,5-di(t-butylperoxy)hexyne-3, le 2,5-diméthyl-2,5-di(t-amylperoxy)hexyne-3, $\alpha,\alpha'$-di-[(t-butyl-peroxy)isopropyl] benzène, le $\alpha,\alpha'$-di-[(t-amyl-peroxy)isopropyl] benzène, le peroxyde de di-t-amyle, le 1,3,5-tri-[(t-butylperoxy)isopropyl]benzène, le 1,3-diméthyl-3-(t-butylperoxy)butanol, le 1,3-diméthyl-3-(t -amylperoxy) butanol et leurs mélanges.

Certains monoperoxycarbonates tels que le OO-tert-butyl-O-(2-éthylhexyl) monoperoxycarbonate, le OO-tert-butyl-O-isopropyl monoperoxycarbonate, le OO-tert-amyl-O-2-éthyl hexyl monoperoxycarbonate et leurs mélanges, peuvent également être utilisés.

Parmi les peroxydes de diacyles, le peroxyde préféré est le peroxyde de benzoyle.

Parmi les peroxycétales, les peroxydes préférés sont choisis dans le groupe constitué par le 1,1-di-(t-butylperoxy)-3,3,5-triméthylcyclohexane, le 4,4-di-(t-butylperoxy)valérate de n-butyle, le 3,3-di-(t-butylperoxy)butyrate d'éthyle, le 2,2-di-(t-amylperoxy)-propane, le 3,6,9-triethyl-3,6,9-trimethyl-1,4,7-triperoxynonane (ou peroxyde de méthyl éthyl cétone trimère cyclique), le 3,3,5,7,7-pentamethyl-1,2,4-trioxepane, le 4,4-bis(t-amylperoxy)valérate de n-butyle, le 3,3-di(t-amylperoxy)butyrate d'éthyle, le 1,1-di(t-butylperoxy)cyclohexane, le 1,1-di(t-amylperoxy)cyclohexane et leurs mélanges.

De préférence, les peroxyesters sont choisis dans le groupe constitué par le tert-butylperoxybenzoate, le tert-butyleperoxy-2-ethylhexanoate, le tert-butyleperoxy-3,5,5-triméthylehexanoate et leurs mélanges.

De manière particulièrement préférée, le peroxyde organique est choisi dans le groupe constitué par le peroxyde de dicumyle, les peroxydes d'aryle ou de diaryle, le peroxyde de diacétyle, le peroxyde de benzoyle, le peroxyde de dibenzoyle, le peroxyde de ditertbutyle, le peroxyde de tertbutylcumyle, le 2,5-bis (tertbutylperoxy)-2,5-diméthylhexane, le n-butyl-4,4'-di(tert-butylperoxy) valérate, le OO-(t-butyl)-O-(2-éthylhexyl) monoperoxycarbonate, le tertio-butyl peroxyisopropylcarbonate, le tertio-butyl peroxybenzoate, le tert-butyl peroxy-3,5,5-triméthylhexanoate, le 1,3(4)-bis(tert-butylperoxyisopropyl)benzène et les mélanges de ces derniers, encore préférentiellement choisis dans le groupe consistant en le peroxyde de dicumyle, le n-butyl-4,4'-di(tert-butylperoxy)-valérate, le OO-(t-butyl) O-(2-éthylhexyl) monoperoxycarbonate, le tertio-butyl peroxyisopropylcarbonate, le tertio-butyl peroxybenzoate, le tert-butyl peroxy-3,5,5-triméthylhexanoate, le 1,3(4)-bis(tert-butylperoxyisopropyl)benzène et les mélanges de ces derniers.

Lorsqu'il est présent, le taux total de peroxyde dans la composition est de préférence supérieur ou égal à 0,3 partie en poids pour cent parties en poids de polymère, plus préférentiellement supérieur ou égal à 0,75 partie en poids pour cent parties en poids de polymère, de préférence compris dans un domaine allant de 0,5 à 5 partie en poids pour cent parties en poids de polymère, en particulier de 0,5 à 3 partie en poids pour cent parties en poids de polymère.

Le matériau composite piézoélectrique de l'invention peut être fabriqué par toute technique connue.

De manière générale, on réalise la dispersion des charges inorganiques piézoélectriques dans la matrice polymérique en présence du liquide ionique, on réticule éventuellement le matériau lorsque la matrice polymérique comprend au moins un élastomère, notamment thermoplastique et/ou diénique, puis on place le matériau composite dans un champ électrique adapté pour permettre une polarisation des charges inorganiques piézoélectriques et obtenir ainsi le matériau composite piézoélectrique.

La dispersion des charges inorganiques piézoélectriques dans la matrice polymérique en présence du liquide ionique s'effectue par tout moyen connu en lui-même de l'homme du métier, notamment par exemple par extrusion bi-vis ou par mélangeage dans un mélangeur interne.

L'étape de polarisation des charges inorganiques est réalisée par des moyens connus et adaptés pour une conversion des charges inorganiques piézoélectriques en charges présentant à l'échelle macroscopique des propriétés piézoélectriques. L'étape de polarisation du dispositif correspond donc à l'application d'un champ électrique aux bornes du dispositif électroactifpour orienter les dipôles des charges piézoélectriques dans la même direction afin d'obtenir une polarisation macroscopique du matériau composite.

La polarisation dépend de la température de polarisation, du champ électrique appliqué et du temps de polarisation.

Avantageusement, la température de polarisation est au moins inférieure de 5°C par rapport à la température de Curie, Tc, la plus faible des charges inorganiques piézoélectriques, plus avantageusement au moins 7°C de moins, encore plus avantageusement au moins 10°C de moins que la température de Curie, Tc, la plus faible des charges inorganiques piézoélectriques. En effet, proche de la température de Curie des charges inorganiques piézoélectriques, l'agitation des dipôles rend plus difficile leur alignement sous un champ électrique.

La température de Curie, Tc, d'un matériau piézoélectrique correspond à la température à laquelle le matériau devient paraélectrique. Ainsi, le cycle d'hystérésis caractéristique du matériau piézoélectrique, et qui est obtenu par le tracé de la polarisation en fonction du champ électrique appliqué au matériau, disparait lorsque la température de Curie est atteinte. La température de Curie est une caractéristique du matériau piézoélectrique.

En particulier, le champ électrique appliqué lors de l'étape de polarisation peut être compris dans un domaine allant de 0,1 à 10 kV/mm, avantageusement de 0,5 à 5 kV/mm.

En particulier, le champ électrique appliqué dépend de la nature de la charge inorganique piézoélectrique et de la durée de polarisation du composite piézoélectrique et du taux de liquide ionique présent dans le matériau. L'homme du métier sait adapter le champ électrique à la charge piézoélectrique et à la durée de polarisation.

En particulier, la durée de polarisation peut être comprise entre 1 minute et 10 heures, de préférence entre 5 minutes et 2 heures.

Avantageusement, le matériau composite piézoélectrique conforme à l'invention est de connectivité 0-3, comprenant des particules de charges piézoélectriques dispersées dans la matrice polymérique. La connectivité dépend de l'organisation spatiale de chaque phase constitutive du matériau composite. Un changement de connectivité entraîne des modifications majeures des propriétés physiques des composites. Dans le cas de systèmes bi-phasiques, la nature de la connectivité est représentée par deux nombres (le premier pour la céramique, le second pour la matrice). Ils indiquent le nombre de directions connectées par la phase considérée. Ainsi, un composite de connectivité 0-3 correspond à un composite constitué par des grains de poudre piézoélectrique dispersées dans la matrice polymérique. Le principal avantage de ce type de composite est la facilité de la mise en œuvre du procédé, ou encore la facilité de réaliser des formes complexes, telles que des surfaces incurvées.

L'invention a également pour objet un dispositif comprenant au moins une couche à base d'au moins un matériau composite piézoélectrique défini ci-dessus et d'au moins deux électrodes conductrices, notamment disposées de part de d'autre de ladite couche.

Les électrodes sont connues de l'homme de l'art. Elles sont déposées sur les faces du matériau composite piézoélectrique de l'invention afin de collecter les charges électriques émises par ledit matériau. Elles peuvent être en regard l'une de l'autre. Leurs dimensions sont adaptées à l'application envisagée.

Les électrodes peuvent être en métal ou oxyde de métaux sous forme de dépôt mince de ces métaux ou de ces oxydes de métaux. Par exemple, les électrodes peuvent être en oxyde d'étain et d'indium, en un matériau métallique, comme l'argent, l'or, le nickel, le palladium, l'aluminium, le cuivre, le titane ou un alliage ou un mélange d'au moins deux de ces matériaux. La formation des électrodes en métal ou en oxyde de métal peut être effectuée par un procédé dit additif, par exemple par impression directe d'une composition fluide ou visqueuse comprenant le métal ou l'oxyde de métal composant les électrodes, aux emplacement souhaités, par exemple par impression par jet d'encre, héliographie, sérigraphie, flexographie, revêtement par pulvérisation (en anglais « spray coating »), dépôt de gouttes (en anglais « drop-casting ») ou par dépôt chimique en phase vapeur. La formation des électrodes en métal ou en oxyde de métal peut correspondre à un procédé soustractif, dans lequel le matériau composant les électrodes est déposé sur la totalité du matériau composite piézoélectrique et dans lequel les portions non utilisées sont ensuite retirées par photolithographie ou ablation laser par exemple. Selon le matériau métallique considéré, le dépôt sur la totalité du matériau composite

piézoélectrique de l'invention peut être réalisé par voie liquide, par pulvérisation cathodique ou par évaporation.

Les électrodes peuvent être souples, telles qu'un mélange d'élastomères thermoplastiques ou diéniques rendus conducteurs, ou telles qu'un polymère conducteur comme par exemple le poly(3,4-éthylènedioxythiopène).

A titre d'électrodes souples, on peut par exemple utiliser une couche E comprenant une composition de caoutchouc conductrice à base d'au moins 50 pce d'élastomère diénique, d'un système de réticulation et d'un noir de carbone graphité ou partiellement graphité.

Les élastomères diéniques qui conviennent pour la composition de caoutchouc conductrice de la couche E sont ceux précédemment décrits pour le matériau composite piézoélectrique. L'élastomère diénique de la composition de caoutchouc conductrice de la couche E peut être identique ou différent de celui du matériau composite piézoélectrique de l'invention, de préférence il est identique à du matériau composite piézoélectrique de l'invention.

Le système de réticulation qui convient pour la composition de caoutchouc conductrice de la couche E est celui précédemment décrit pour le matériau composite piézoélectrique de l'invention. Le système de réticulation de la composition de caoutchouc conductrice de la couche E peut être identique ou différent de celui du matériau composite piézoélectrique de l'invention, de préférence il est identique à celui du matériau composite piézoélectrique de l'invention.

Le noir de carbone graphité ou partiellement graphité est tout noir de carbone graphité ou partiellement graphité ayant un indice d'absorption d'huile OAN supérieur ou égal à 155 ml/100 g, plus préférentiellement supérieur ou égal à 160 ml/100 g.

De préférence, le noir de carbone graphité ou partiellement graphité peut avoir une taille de particules comprise dans un domaine allant de 50 à 500 $\mu$m. La quantité de noir graphité ou partiellement graphité dans la composition de caoutchouc conductrice de la couche E est comprise dans un domaine allant de 10 % à 40% en volume, de préférence de 15 % à 30 % en volume par rapport au volume total de la composition de caoutchouc conductrice. Préférentiellement, la composition de caoutchouc conductrice de la couche E ne comprend pas de charge inorganique piézoélectrique.

La composition de caoutchouc conductrice de la couche E est fabriquée dans un mélangeur approprié, en utilisant par exemple deux phases de préparation successives selon une procédure générale bien connue de l'homme du métier : une première phase de travail ou malaxage thermomécanique (parfois qualifiée de phase « non-productive ») à haute température où sont mélangés les constituants de la couche E à l'exception du système de réticulation, jusqu'à une température maximale comprise entre 80°C et 190°C, de préférence entre 80°C et 150°C, suivie d'une seconde phase de travail mécanique (parfois qualifiée de phase « productive ») à plus basse température, typiquement inférieure à 80°C, par exemple entre 60°C et 80°C, phase de finition au cours de laquelle est incorporé le système de réticulation. A l'issue de la phase productive, la composition de caoutchouc conductrice est extrudée ou calandrée pour former une couche souple E.

Le dispositif de l'invention peut être fabriqué par tout moyen connu de l'homme du métier. Les couches E formant les électrodes sont déposées sur les faces du matériau composite piézoélectrique de l'invention afin de collecter les charges électriques émises par ledit matériau. Le dispositif selon l'invention est avantageusement relié à un organe électronique afin de capter les impulsions électriques émises et d'utiliser cette information.

A titre d'exemple de fabrication du dispositif avec des couches E souples, on peut citer le protocole suivant : les couches E et le matériau composite piézoélectrique peuvent être fabriquées séparément comme expliqué ci-dessus puis le matériau composite piézoélectrique est placé entre deux couches E, identiques ou différentes, de préférence identiques, conductrices pour obtenir un assemblage, puis on applique une pression sur l'assemblage et on réticule éventuellement l'assemblage pour obtenir le dispositif selon l'invention. Les couches peuvent être successivement déposées dans un moule adapté, appelé moule de cuisson, qui peut avoir toute dimension. On peut utiliser une pression allant de 1 000 000 à 20 000 000 Pa, avantageusement allant de 1 500 000 à 10 000 000 Pa. Cette pression est appliquée à l'assemblage. La durée de la compression est adaptée en fonction de la pression choisie ; elle peut par exemple durer de 5 min à 90 min. La réticulation peut être réalisée par cuisson, c'est-à-dire en chauffant l'assemblage à une température généralement comprise entre 130°C et 200°C, pendant un temps suffisant qui peut varier par exemple entre 5 et 90 min en fonction notamment de la température de cuisson, du système de réticulation adopté et de la cinétique de réticulation des compositions considérées. Les étapes de mise sous pression et de réticulation peuvent être simultanées. Par exemple, lorsque les couches sont déposées dans un moule de cuisson, ce moule peut être déposé dans une presse à plateaux où l'assemblage va être cuit sous pression.

Lorsque les couches E sont des couches métalliques, on peut fabriquer le matériau composite piézoélectrique comme expliqué ci-dessus, puis on applique les couches E selon un des procédés de fabrication de ces couches comme expliqué ci-dessus.

Le procédé de préparation du dispositif de l'invention peut comprendre avantageusement une étape de polarisation décrite ci-dessus.

Le dispositif est avantageusement relié à un organe électronique afin de capter les impulsions électriques émises et d'utiliser cette information.

Le dispositif selon l'invention et mentionné ci-dessus peut être utilisé en association avec un capteur.

L'invention s'étend aussi à l'utilisation d'un tel matériau composite piézoélectrique défini ci-dessus pour la fabrication de pièces structurelles et de films supportés déposés sur tout ou partie de la surface d'un tel support.

En particulier, on utilise le matériau composite piézoélectrique selon l'invention et/ou le dispositif selon l'invention pour permettre la détection d'une contrainte mécanique en surface dudit matériau composite par effet piézoélectrique direct.

La détection d'une contrainte mécanique peut être réalisée dans un très large domaine d'applications technique tel que l'aéronautique, l'automobile, la santé, les pneumatiques, le transport, etc...

L'invention a également pour objet un pneumatique comprenant le dispositif mentionné ci-dessus comprenant le matériau composite piézoélectrique selon l'invention et des électrodes. En particulier, ledit dispositif peut être fixé par exemple sur la couche étanche intérieure dudit pneumatique, c'est-à-dire sur la couche qui est en contact avec l'air de gonflage du pneumatique. La fixation peut être réalisée par des moyens classiques connus de l'homme de l'art comme le grattage du badigeon, l'utilisation de vulcanisation à froid ou encore la fusion de TPE. La fixation peut se faire par collage par adhésif.

D'autres avantages apparaîtront à la lecture de la description suivante, qui se réfère aux exemples donnés à titre non limitatif.

Exemples :

Les exemples présentés ci-dessous ont pour but de comparer les propriétés piézoélectriques des matériaux composites piézoélectriques M1, M2 et M3, conformes à l'invention par rapport à un matériau composite piézoélectrique T non conforme.

Sauf mention contraire, les taux des différents constituants des matériaux composites piézoélectriques présentés dans le tableau 1 sont exprimés en partie en poids pour 100 parties en poids de polymère. Tous les matériaux composites présentent un taux de charges inorganiques piézoélectriques de 33 % en volume par rapport au volume total du matériau composite.

**[Table 1]**

| Matériau | T | M1 | M2 | M3 |
|---|---|---|---|---|
| Matrice polymérique (1) | 100,00 | 100,00 | 100,00 | 100,00 |
| Charge inorganique piézoélectrique (2) | 320,10 | 322,80 | 326,30 | 334,60 |
| Liquide ionique (3) | (-) | 1,00 | 2,00 | 5,00 |
| Système de réticulation (4) | 0,75 | 0,75 | 0,75 | 0,75 |

(1) Matrice polymérique : Copolymère Styrène-Butadiène (SBR) polymérisé en solution (S-SBR), non fonctionnel, non étendu. Sa microstructure est la suivante : 24 % molaire de motifs polybutadiène 1,2 par rapport à la partie butadiènique et 26,5 % en poids de motifs styrène par rapport au poids total du copolymère. Il a une Tg = -48°C. La température de transition vitreuse, Tg, est mesurée de manière connue par DSC (« Différential Scanning Calorimetry) selon la norme ASTM D3418 de 1999. La microstructure du S-SBR (répartition relative des unités butadiène 1,2-vinyl, 1,4-trans et 1,4-cis) et la détermination quantitative du taux massique de styrène dans le S-SBR sont déterminées par spectroscopie proche infrarouge (NIR). Le principe de la méthode repose sur la loi de Beer-Lambert généralisée à un système multi-composants. La méthode étant indirecte, elle fait appel à un étalonnage multivarié [Vilmin, F.; Dussap, C.; Coste, N. Applied Spectroscopy 2006, 60, 619-29] réalisé à l'aide d'élastomères étalons de composition déterminée par RMN $^{13}$C. Le taux de styrène et la microstructure sont alors calculés à partir du spectre NIR d'un film d'élastomère d'environ 730 $\mu$m d'épaisseur. L'acquisition du spectre est réalisée en mode transmission entre 4000 et 6200 cm$^{-1}$ avec une résolution de 2 cm$^{-1}$, à l'aide d'un spectromètre proche infrarouge à transformée de Fourier Bruker Tensor 37 équipé d'un détecteur InGaAs refroidi par effet Peltier.
(2) Charge inorganique piézoélectrique : $BaTiO_3$ : diamètre moyen des charges : 500 nm, densité 5,85 g/cm$^3$ commercialisée par Inframat Advanced Materials.
(3) Liquide ionique : « ENIM Ac » (Acétate de 1-éthyl-3-méthylimidazolium) commercialisé par la société Sigma-Aldrich. Température de fusion = -20°C mesurée comme décrit dans la description
(4) Système de réticulation : « Luperox 231 » (1,1-di-(t-butylperoxy)-3,3,5-triméthylcyclohexane supporté à 40 % poids sur du carbonate de calcium) commercialisé par la société Arkéma.

Procédé de préparation du matériau composite piézoélectrique

Les matériaux composites piézoélectriques sont préparés dans un mélangeur interne « polylab » de 85 cm$^3$, rempli à 70% et dont la température initiale de cuve est de 80°C, la matrice polymérique, les charges inorganiques piézoélectriques et le liquide ionique pour les matériau composite M1, M2 et M3. Puis, un travail thermomécanique est

conduit pendant 3 min à 80 tours/min jusqu'à atteindre une température maximale de tombée de 150°C (phase non-productive). On récupère le mélange ainsi obtenu, on le refroidit puis on ajoute le système de réticulation sur un mélangeur externe (homo-finisseur) à une température de 25°C, en mélangeant l'ensemble en 12 passes croisées (phase productive). Les matériaux ainsi obtenus sont ensuite calandrés sous la forme de plaques (épaisseur de 2 à 3 mm) et cuits à l'aide d'une presse à 150°C durant 20 minutes dans un moule de 330 $cm_2$ sous 8 tonnes.

A l'issue de cette opération, il est tout à fait possible de découper les stratifiés avec un emporte-pièce ou tout autre moyen de découpe pour réaliser un dispositif piézoélectrique avec ses deux électrodes à la forme et la taille souhaitée.

On confectionne ensuite le dispositif. Plus précisément, on découpe ensuite des parallélépipèdes de 20 mm × 80 mm × 2 mm (largeur × longueur × épaisseur) (ensuite aussi appelés éprouvettes) dans les plaques obtenues précédemment. Pour faciliter la polarisation et permettre les mesures, les éprouvettes sont métallisées sur les deux faces de plus grandes dimensions. La métallisation, ici avec de l'or, peut être réalisée manuellement avec une laque, ou par pulvérisation cathodique ou toute autre méthode connue. En l'espèce, on dépose à l'aide d'un métaliseur (« DENTON DESK V » de la société DENTON VACUUM) les deux électrodes en or avec un ampérage de 40 mA pendant 25 secondes.

Le dispositif est ensuite placé dans un bain d'huile silicone (« BLUESIL FLD 47V5000 » commercialisée par la société Bluestar Silicones) pour l'étape de polarisation. On applique un champ électrique avec un générateur électrique « MCP Lab Electronics SPN6000A » pendant 10 min aux deux bornes de l'éprouvette (i.e. connectée aux deux faces métallisées). La polarisation s'effectue à une température de 60°C. Deux intensités de champs électriques continus sont utilisées : 1V/μm (condition A) et 4V/μm (condition B). Une fois polarisée, les éprouvettes sont court-circuitées pour évacuer un maximum de charges résiduelles.

Mesure du coefficient piézoélectrique $d_{33}$:

Le coefficient piézoélectrique $d_{33}$ permet de déterminer le pouvoir de déformation d'un matériau composite, cette déformation s'effectuant parallèlement à l'axe de polarisation.

La mesure de la réponse électromécanique des éprouvettes s'effectue sur un banc de mesures dynamiques. L'échantillon est précontraint avec une force de 10 N puis il est sollicité en compression avec une force de 5 N à la fréquence de 1 Hz et à la température de 23°C.

Le signal généré par le matériau composite piézoélectrique est récupéré aux bornes de l'échantillon par un appontage de mors spécifique, puis amplifié et mesuré sur un oscilloscope.

A partir de la tension crête-crête lue sur l'oscilloscope, on en déduit la charge Q (pC picocoulomb) libérée à chaque sollicitation mécanique. Ainsi le coefficient piézoélectrique $d_{33}$ (pC/N (picocoulomb/newton)) peut être calculé. Le coefficient $d_{33}$, connu de l'homme de l'art, représente le coefficient piézoélectrique mesuré par application d'une contrainte dans la direction parallèle à la direction de polarisation de l'échantillon. Dans le cas d'un échantillon parallélépipédique, la direction de polarisation correspond à la plus faible épaisseur (direction 3) et l'application de la contrainte se fait selon la même épaisseur (direction 3).

La notation suivante peut être adoptée :

$$d_{33} = \Delta P3 / \Delta\sigma 3,$$

avec ΔP3 la variation de polarisation macroscopique dans la direction 3 et Δσ3 la contrainte appliquée dans la direction 3.

Le calcul de ce coefficient se fait par la formule suivante :

$$d_{33} = [Q\ (pC)\ x\ \text{épaisseur}\ (m)] / [Force\ (N)\ x\ Longueur\ (m)]$$

dans le cas où l'électrode couvre l'entièreté de la surface de l'éprouvette.

Résultats

Le tableau 2 présente les résultats de mesure de coefficient piézoélectrique $d_{33}$ pour les trois matériaux composites piézoélectriques de l'invention par rapport au matériau composite piézoélectrique témoin, mesuré après une polarisation selon la condition A ou la condition B.

**[Table 2]**

| Coefficient piézoélectrique $d_{33}$ | T | M1 | M2 | M3 |
|---|---|---|---|---|
| Condition A : 1 V/μm | 0,1 | 0,3 | 2,0 | 2,8 |

(suite)

| Coefficient piézoélectrique $d_{33}$ | T | M1 | M2 | M3 |
|---|---|---|---|---|
| Condition B : 4V/µm | 0,7 | 2,0 | 6,5 | n.m |
| n.m= non mesuré. | | | | |

Les résultats du tableau 2 montrent que pour une condition de polarisation donnée, par exemple la condition A, le coefficient piézoélectrique $d_{33}$ des matériaux composites M1, M2, M3 selon l'invention est très significativement amélioré par rapport à celui du matériau composite T hors invention. Ce coefficient augment d'au moins d'un facteur de 300 % (comparaison du matériau composite M1 selon l'invention par rapport au matériau composite T hors invention). Le liquide ionique permet donc, de manière surprenante, d'améliorer les propriétés piézoélectriques d'un matériau composite dans lequel il est ajouté, après polarisation dans les mêmes conditions de température, de temps, et d'intensité du champ électrique qu'un matériau composite ne comprenant pas de liquide ionique.

Les résultats présentés dans le tableau 2 montrent également que pour obtenir des propriétés piézoélectriques données pour un matériau composite selon l'invention (par exemple un coefficient piézoélectrique $d_{33}$=0,2), il est possible, soit de moduler la force électrique du champ électrique (matériau composite M1, condition B), soit de moduler la quantité de liquide ionique ajoutée (matériau composite M2, condition A). Les propriétés piézoélectriques des matériaux composites de l'invention peuvent donc être modulées facilement et simplement, ce qui représente un autre avantage de la présente invention.

**Revendications**

1. Matériau composite piézoélectrique à base d'une matrice polymérique et de charges inorganiques piézoélectriques, **caractérisé en ce que** ledit matériau comprend en outre au moins un liquide ionique de formule générale $Q^+A^-$, dans laquelle $Q^+$ représente un cation choisi parmi les cations ammoniums quaternaires et les cations phosphoniums quaternaires et $A^-$ représente tout anion qui sont adaptés à former ensemble un sel liquide à une température inférieure à 100°C.

2. Matériau composite piézoélectrique selon la revendication 1, dans lequel Q+ est un cation ammonium quartenaire choisi dans le groupe constitué par les cations imidazolium, les cations pyrazolium, les cations pyridinium, les cations pyrimidinium, les cations tétra-alkyl(C1-C6)ammonium, les cations guanidium et les cations pyrrolidium.

3. Matériau composite piézoélectrique selon l'une quelconque des revendications précédentes, dans lequel Q+ est un cation imidazolium répondant à la formule (I)

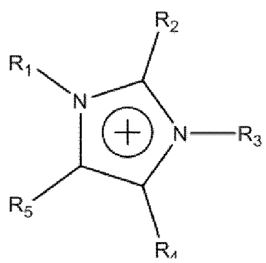

(I)

dans laquelle R1 représente un groupe alkyle comportant de 1 à 15 atomes de carbone, de préférence de 1 à 10 atomes de carbone, éventuellement substitué par un ou plusieurs groupements aryles en C6-C30, thiols, hydroxy ou interrompu par un ou plusieurs atomes d'oxygène ou de soufre ou par un ou plusieurs groupements NR', R2, R3, R4, R5 et R', identiques ou différents, représentent chacun un atome d'hydrogène ou un groupe alkyle comportant de 1 à 6 atomes, de carbone de préférence de 1 à 4 atomes de carbone, ou un groupe aryle en C6-C30, éventuellement substitué par un ou plusieurs groupes alkyles en C1 -C4.

4. Matériau composite piézoélectrique selon la revendication 4, dans lequel Q+ est choisi dans le groupe constitué par le 1-éthyle-3-méthylimidazolium, le 1-butyl-3-méthylimidazolium, le 1-héxyl-m-méthylimidazolium, le 1-octyl-3-méthylimidazolium, le 1-décyl-3-méthylimidazolium, le 1,3-dibutylimidazolium et le 1-butyl-2,3-diméthylimidazolium.

5. Matériau composite piézoélectrique selon l'une quelconque des revendications précédentes, dans lequel $A^-$ est choisi dans le groupe constitué par l'acétate, le trifluoroacétate, le propionate, le chlorure, l'hydroxyle, le sulfate, le trifluorométhanesulfonate, le pentafluorométhanesulfonate et les phosphates ; de préférence $A^-$ est l'acétate ou le propionate.

6. Matériau composite piézoélectrique selon l'une quelconque des revendications précédentes, le taux de liquide ionique est supérieur ou égal à 0,1 parties en poids pour cent partie en poids de polymère, de préférence est compris dans un domaine allant de 0,1 à 15 parties en poids pour cent partie en poids de polymère, plus préférentiellement de 0,5 à 12 parties en poids pour cent partie en poids de polymère, plus préférentiellement encore de 1 à 10 parties en poids pour cent partie en poids de polymère.

7. Matériau composite piézoélectrique selon l'une quelconque des revendications précédentes, dans lequel la charge inorganique piézoélectrique est choisie parmi les céramiques piézoélectriques, avantageusement choisie parmi les oxydes ferroélectriques, avantageusement ayant une structure pérovskite.

8. Matériau composite piézoélectrique selon l'une quelconque des revendications précédentes, dans lequel la charge inorganique piézoélectrique est choisie parmi le titanate de baryum, le titanate de plomb, le titano-zirconate de plomb, le niobate de plomb, le niobate de lithium, le niobate de potassium et leurs mélanges, plus préférentiellement la charge inorganique piézoélectrique est choisie parmi le titanate de baryum, le titano-zirconate de plomb, le niobate de potassium et leurs mélanges.

9. Matériau composite piézoélectrique selon l'une quelconque des revendications précédentes, dans lequel le taux de charges inorganiques piézoélectriques est compris dans un domaine allant de 5 % à 80 % en volume par rapport au volume total dudit matériau, plus préférentiellement de 6 % à 60 %, plus préférentiellement encore de 7 % à 50 %.

10. Matériau composite piézoélectrique selon l'une quelconque des revendications précédentes, dans lequel la matrice polymérique comprend au moins un polymère choisi dans le groupe constitué par les polymères thermoplastiques, les élastomères thermoplastiques, les polymères thermodurcissables, les élastomères diéniques et les mélanges de ces polymères.

11. Matériau composite piézoélectrique selon l'une quelconque des revendications précédentes, dans lequel la matrice polymérique comprend au moins un élastomère thermoplastique et/ou un élastomère diénique.

12. Matériau composite piézoélectrique selon l'une quelconque des revendications précédentes, dans lequel la matrice polymérique comprend au moins un élastomère diénique choisi dans le groupe constitué par le caoutchouc naturel, les copolymères d'éthylène-propylène-monomère diénique, les polyisoprènes de synthèse, les polybutadiènes, les copolymères de butadiène, les copolymères d'isoprène et les mélanges de ces élastomères diéniques.

13. Matériau composite piézoélectrique selon l'une quelconque des revendications 12, comprenant en outre au moins un système de réticulation, de préférence le système de réticulation comprend au moins un peroxyde.

14. Dispositif comprenant au moins une couche à base d'au moins un matériau composite piézoélectrique et d'au moins deux électrodes disposées de part et d'autre de ladite couche, **caractérisé en ce que** ledit matériau composite piézoélectrique est défini selon l'une quelconque des revendication 1 à 13.

15. Pneumatique comprenant au moins un dispositif piézoélectrique défini selon la revendication 14.

**Patentansprüche**

1. Piezoelektrischer Verbundwerkstoff auf Basis einer Polymermatrix und piezoelektrischer anorganischer Füllstoffe, **dadurch gekennzeichnet, dass** der Werkstoff weiterhin mindestens eine ionische Flüssigkeit der allgemeinen Formel $Q^+A^-$ umfasst, in der $Q^+$ für ein Kation steht, das aus quartären Ammoniumkationen und quartären Phosphoniumkationen ausgewählt ist, und $A^-$ für ein beliebiges Anion steht, die so ausgebildet sind, dass sie zusammen ein bei einer Temperatur unter 100°C flüssiges Salz bilden.

2. Piezoelektrischer Verbundwerkstoff nach Anspruch 1, wobei Q+ ein quartäres Ammoniumkation ist, das aus der Gruppe bestehend aus Imidazoliumkationen, Pyrazoliumkationen, Pyridiniumkationen, Pyrimidiniumkationen, Tetra(C1-C6)alkylammoniumkationen, Guanidiumkationen und Pyrrolidiumkationen ausgewählt ist.

3. Piezoelektrischer Verbundwerkstoff nach einem der vorhergehenden Ansprüche, wobei $Q^+$ ein Imidazoliumkation ist, das der Formel (I) entspricht:

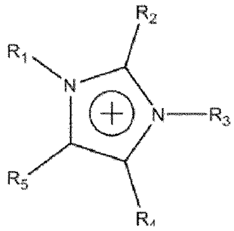

(I)

wobei R1 für eine Alkylgruppe mit 1 bis 15 Kohlenstoffatomen, vorzugsweise 1 bis 10 Kohlenstoffatomen, die gegebenenfalls durch eine oder mehrere C6-C30-Aryl-, Thiol- oder Hydroxygruppen substituiert oder durch ein oder mehrere Sauerstoff- oder Schwefelatome oder durch eine oder mehrere Gruppen NR' unterbrochen ist, steht und R2, R3, R4, R5 und R', die gleich oder verschieden sind, jeweils für ein Wasserstoffatom oder eine Alkylgruppe mit 1 bis 6 Kohlenstoffatomen, vorzugsweise 1 bis 4 Kohlenstoffatomen, oder eine C6-C30-Arylgruppe, die gegebenenfalls durch eine oder mehrere C1-C4-Alkylgruppen substituiert ist, stehen.

4. Piezoelektrischer Verbundwerkstoff nach Anspruch 4, wobei Q+ aus der Gruppe bestehend aus 1-Ethyl-3-methylimidazolium, 1-Butyl-3-methylimidazolium, 1-Hexylm-methylimidazolium, 1-Octyl-3-methylimidazolium, 1-Decyl-3-methylimidazolium, 1,3-Dibutylimidazolium und 1-Butyl-2,3-dimethylimidazolium ausgewählt ist.

5. Piezoelektrischer Verbundwerkstoff nach einem der vorhergehenden Ansprüche, wobei $A^-$ aus der Gruppe bestehend aus Acetat, Trifluoracetat, Propionat, Chlorid, Hydroxyl, Sulfat, Trifluormethansulfonat, Pentafluormethansulfonat und Phosphaten ausgewählt ist; vorzugsweise $A^-$ Acetat oder Propionat ist.

6. Piezoelektrischer Verbundwerkstoff nach einem der vorhergehenden Ansprüche, wobei der Gehalt an ionischer Flüssigkeit größer oder gleich 0,1 Gewichtsteile pro hundert Gewichtsteile Polymer ist, vorzugsweise in einem Bereich von 0,1 bis 15 Gewichtsteilen pro 100 Gewichtsteile Polymer, weiter bevorzugt von 0,5 bis 12 Gewichtsteilen pro 100 Gewichtsteile Polymer, noch weiter bevorzugt von 1 bis 10 Gewichtsteilen pro hundert Gewichtsteile Polymer, liegt.

7. Piezoelektrischer Verbundwerkstoff nach einem der vorhergehenden Ansprüche, wobei der piezoelektrische anorganische Füllstoff aus piezoelektrischer Keramik ausgewählt ist, vorteilhafterweise aus ferroelektrischen Oxiden, vorteilhafterweise mit Perowskit-Struktur, ausgewählt ist.

8. Piezoelektrisches Verbundmaterial nach einem der vorhergehenden Ansprüche, wobei der piezoelektrische anorganische Füllstoff aus Bariumtitanat, Bleititanat, Bleizirconattitanat, Bleiniobat, Lithiumniobat, Kaliumniobat und Mischungen davon ausgewählt ist und der piezoelektrische anorganische Füllstoff weiter bevorzugt aus Bariumtitanat, Bleizirconattitanat, Kaliumniobat und Mischungen davon ausgewählt ist.

9. Piezoelektrischer Verbundwerkstoff nach einem der vorhergehenden Ansprüche, wobei der Gehalt an piezoelektrischen anorganischen Füllstoffen in einem Bereich von 5 bis 80 Vol.-%, bezogen auf das Gesamtvolumen des Werkstoffs, weiter bevorzugt von 6 bis 60 % und noch weiter bevorzugt von 7 bis 50 % liegt.

10. Piezoelektrischer Verbundwerkstoff nach einem der vorhergehenden Ansprüche, wobei die Polymermatrix mindestens ein Polymer umfasst, das aus der Gruppe bestehend aus thermoplastischen Polymeren, thermoplastischen Elastomeren, duroplastischen Polymeren, Dienelastomeren und Mischungen dieser Polymere ausgewählt ist.

11. Piezoelektrischer Verbundwerkstoff nach einem der vorhergehenden Ansprüche, wobei die Polymermatrix mindestens ein thermoplastisches Elastomer und/oder ein Dienelastomer umfasst.

12. Piezoelektrischer Verbundwerkstoff nach einem der vorhergehenden Ansprüche, wobei die Polymermatrix mindestens ein Dienelastomer umfasst, das aus der Gruppe bestehend aus Naturkautschuk, Ethylen-Propylen-Dien-Monomer-Copolymeren, synthetischen Polyisoprenen, Polybutadienen, Butadien-Copolymeren, Isopren-Copolymeren und Mischungen dieser Dienelastomere ausgewählt ist.

13. Piezoelektrischer Verbundwerkstoff nach einem der Ansprüche 12, ferner umfassend mindestens ein Vernetzungssystem, wobei das Vernetzungssystem vorzugsweise mindestens ein Peroxid umfasst.

14. Vorrichtung, umfassend mindestens eine Schicht auf Basis mindestens eines piezoelektrischen Verbundwerkstoffs und mindestens zwei auf beiden Seiten der Schicht angeordnete Elektroden, **dadurch gekennzeichnet, dass** der piezoelektrische Verbundwerkstoff nach einem der Ansprüche 1 bis 13 definiert ist.

15. Reifen, umfassend mindestens eine piezoelektrische Vorrichtung gemäß Anspruch 14.

**Claims**

1. Piezoelectric composite material based on a polymeric matrix and on piezoelectric inorganic fillers, **characterized in that** said material additionally comprises at least one ionic liquid of general formula $Q^+A^-$, in which $Q^+$ represents a cation chosen from quaternary ammonium cations and quaternary phosphonium cations and $A^-$ represents any anion capable of forming together a liquid salt at a temperature of less than 100°C.

2. Piezoelectric composite material according to Claim 1, in which $Q^+$ is a quaternary ammonium cation selected from the group consisting of imidazolium cations, pyrazolium cations, pyridinium cations, pyrimidinium cations, tetra($C_1$-$C_6$)alkylammonium cations, guanidium cations and pyrrolidium cations.

3. Piezoelectric composite material according to either one of the preceding claims, in which $Q^+$ is an imidazolium cation corresponding to the formula (I):

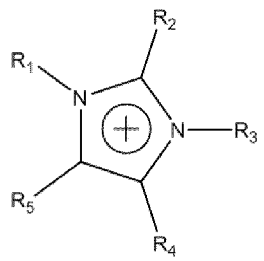

(I)

in which $R_1$ represents an alkyl group comprising from 1 to 15 carbon atoms, preferably from 1 to 10 carbon atoms, optionally substituted by one or more $C_6$-$C_{30}$ aryl, thiol or hydroxy groups or interrupted by one or more oxygen or sulfur atoms or by one or more NR' groups, $R_2$, $R_3$, $R_4$, $R_5$ and R', which are identical or different, each represent a hydrogen atom or an alkyl group comprising from 1 to 6 carbon atoms, preferably from 1 to 4 carbon atoms, or a $C_6$-$C_{30}$ aryl group, optionally substituted by one or more $C_1$-$C_4$ alkyl groups.

4. Piezoelectric composite material according to Claim 4, in which $Q^+$ is selected from the group consisting of 1-ethyl-3-methylimidazolium, 1-butyl-3-methylimidazolium, 1-hexyl-m-methylimidazolium, 1-octyl- 3-methylimidazolium, 1-decyl-3-methylimidazolium, 1,3-dibutylimidazolium and 1-butyl-2,3-dimethylimidazolium.

5. Piezoelectric composite material according to any one of the preceding claims, in which $A^-$ is selected from the group consisting of acetate, trifluoroacetate, propionate, chloride, hydroxide, sulfate, trifluoromethanesulfonate, pentafluoromethanesulfonate and phosphates; preferably, $A^-$ is acetate or propionate.

6. Piezoelectric composite material according to any one of the preceding claims, the content of ionic liquid is greater than or equal to 0.1 part by weight per hundred parts by weight of polymer, preferably is within a range extending from 0.1 to 15 parts by weight per hundred parts by weight of polymer, more preferentially from 0.5 to 12 parts by weight per hundred parts by weight of polymer, more preferentially still from 1 to 10 parts by weight per hundred parts by weight of

polymer.

7. Piezoelectric composite material according to any one of the preceding claims, in which the piezoelectric inorganic filler is chosen from piezoelectric ceramics, advantageously chosen from ferroelectric oxides, advantageously having a perovskite structure.

8. Piezoelectric composite material according to any one of the preceding claims, in which the piezoelectric inorganic filler is chosen from barium titanate, lead titanate, lead zirconate titanate, lead niobate, lithium niobate, potassium niobate and their mixtures; more preferentially, the piezoelectric inorganic filler is chosen from barium titanate, lead zirconate titanate, potassium niobate and their mixtures.

9. Piezoelectric composite material according to any one of the preceding claims, in which the content of piezoelectric inorganic fillers is within a range extending from 5% to 80% by volume, with respect to the total volume of said material, more preferentially from 6% to 60% and more preferentially still from 7% to 50%.

10. Piezoelectric composite material according to any one of the preceding claims, in which the polymeric matrix comprises at least one polymer selected from the group consisting of thermoplastic polymers, thermoplastic elastomers, thermosetting polymers, diene elastomers and the mixtures of these polymers.

11. Piezoelectric composite material according to any one of the preceding claims, in which the polymeric matrix comprises at least one thermoplastic elastomer and/or one diene elastomer.

12. Piezoelectric composite material according to any one of the preceding claims, in which the polymeric matrix comprises at least one diene elastomer selected from the group consisting of natural rubber, ethylene/propylene/-diene monomer copolymers, synthetic polyisoprenes, polybutadienes, butadiene copolymers, isoprene copolymers and the mixtures of these diene elastomers.

13. Piezoelectric composite material according to either one of Claims 11 and 12, additionally comprising at least one crosslinking system; preferably, the crosslinking system comprises at least one peroxide.

14. Device comprising at least one layer based on at least one piezoelectric composite material and at least two electrodes positioned on either side of said layer, **characterized in that** said piezoelectric composite material is defined according to any one of Claims 1 to 13.

15. Tyre comprising at least one piezoelectric device defined according to Claim 14.

**Fig. 1.**

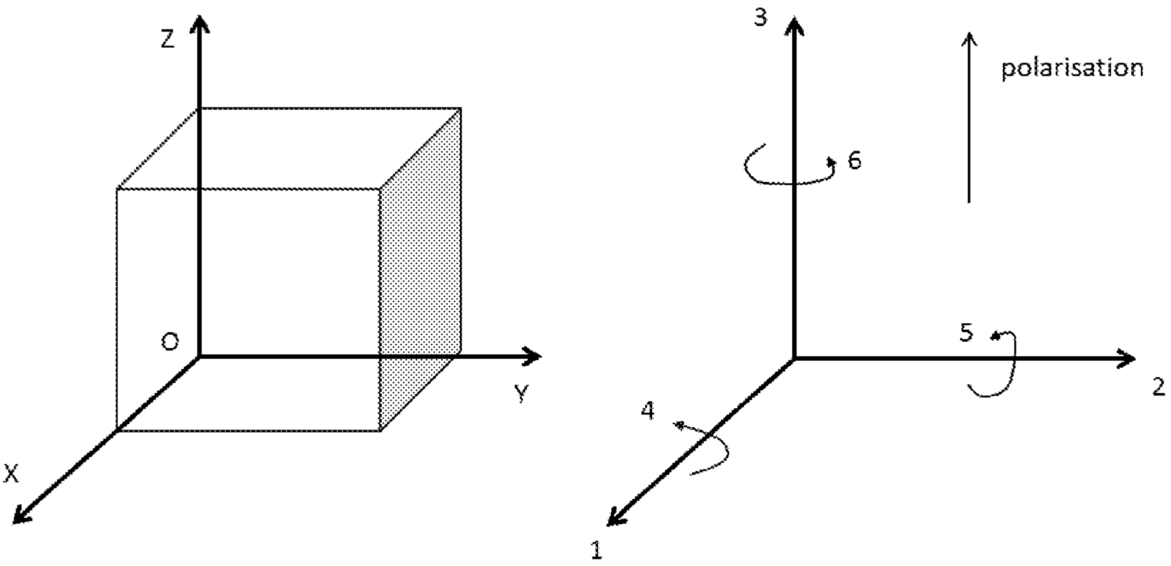

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- US 2015134061 A1
- WO 2016157092 A1
- EP 2654094 A1
- WO 2019243750 A1
- US 20190284423 A1
- US 2019058108 A1
- EP 2071584 A1


### Littérature non-brevet citée dans la description


- **CAPSAL et al.** *Journal of non-crystalline solids*, 2010, vol. 356, 629-634
- **FURUKAWA et al.** *Jpn. J. Appl. Phys.*, 1976, vol. 15, 2119
- **HANNER et al.** *Ferroelectrics*, 1989, vol. 100, 255-260
- **LIU et al.** *Materials Science and Engineering*, 2006, vol. 127, 261-266
- **RUJIJANAGUL et al.** *Journal of Materials Science Letters*, 2001, vol. 20, 1943-1945
- Ionic Liquids, Physicochemical properties. **SUO-JIANG ZHANG** ; **XINGMEI LU** ; **QING ZHOU** ; **XIAOHUA LI** ; **XIANGPING ZHANG** ; **SHUCAI LI**. Science. Elsevier, 2009
- **PERNAK J., RZEMIENIECKI T.** ; **MATERNA K.** Ionic liquids ''in a nutshell'' (history, properties and development). *CHEMIK*, 2016, vol. 70 (9), 471-480
- **FREEMANTLE, M.** An Introduction to Ionic Liquids. Royal Society of Chemistry, 2010
- **VILMIN, F.** ; **DUSSAP, C.** ; **COSTE, N**. *Applied Spectroscopy*, 2006, vol. 60, 619-29